# EUROPEAN PATENT SPECIFICATION

(11) **EP 4 583 083 B1**
(45) Date of publication and mention of the grant of the patent: **04.11.2026**
(21) Application number: 24834589.4
(22) Date of filing: 14.08.2024
(51) Int. Cl.: G09F 9/30, H04M 1/02, G06F 1/16

(54) **ROTATING MECHANISM AND FOLDABLE ELECTRONIC DEVICE**
ROTATIONSMECHANISMUS UND KLAPPBARE ELEKTRONISCHE VORRICHTUNG
MÉCANISME ROTATIF ET DISPOSITIF ÉLECTRONIQUE PLIABLE

(30) Priority: 21.11.2023 CN 202311549715
(43) Date of publication of application: 09.07.2025
(73) Proprietor: Honor Device Co., Ltd., Shenzhen, Guangdong 518040 (CN)
(72) Inventor: HUANG, Shengxian, Shenzhen, Guangdong 518040 (CN); DONG, Shaohong, Shenzhen, Guangdong 518040 (CN)
(74) Representative: Gill Jennings & Every LLP
(86) International application number: PCT/CN2024/112088
(87) International publication number: WO 2025/107749

(56) References cited:
- CN-A- 113 141 427
- CN-A- 113 194 183
- CN-A- 115 150 486
- CN-A- 115 705 074
- CN-A- 116 838 697
- CN-A- 117 351 844
- CN-U- 219 087 161
- KR-A- 20210 009 574
- KR-A- 20230 049 264
- US-A1- 2021 181 808
- US-B2- 11 579 658

## Description

### TECHNICAL FIELD

This application relates to the field of electronic product technologies, and in particular, to a rotation mechanism and a foldable electronic device.

### BACKGROUND

With the development of science and technologies, an appearance (ID) form of an electronic device (for example, a mobile phone or a tablet computer) tends to develop from a bar-type machine to a foldable machine. The foldable electronic device has a large-area display in an open state and therefore fully meets visual experience of a consumer; and has a small size in a closed state and therefore is easy to carry. A rotating shaft is a core component of the foldable electronic device, and a main swing arm in the rotating shaft supports the movement of a middle frame. In the related technology, when a foldable electronic device is in a flattened state, a main swing arm has a vacancy, which may cause redundancy and arching of a display, affecting use experience of a user. US 11,579,658 B2 discloses a foldable display with hinged subassemblies and perforated support plate, including a base, a first movable member, and a second movable member, wherein the base is provided with a first rotating groove and a second rotating groove that are arranged opposite to each other in a width direction of a rotation mechanism. The first movable member is mounted in the first rotating groove and is configured to rotate and slide along the first rotating groove, and the second movable member is mounted in the second rotating groove and is configured to rotate and slide along the second rotating groove. The first movable member and the second movable member are further arranged such that they are rotatable toward each other to enable folding of the first movable member with respect to the second movable member. US 2021/0181808 A1 discloses a hinge with symmetric linkages, sliding supports, and geared synchronization.

### SUMMARY

This application provides a rotation mechanism and a foldable electronic device, which can reduce a vacancy of a foldable electronic device in a flattened state, thereby resolving technical problems that a display is prone to redundancy and arching. The invention is defined by the independent claim

According to a first aspect, this application provides a rotation mechanism. The rotation mechanism includes a base, a first main swing arm, and a second main swing arm. The base is provided with a first rotating groove and a second rotating groove, and the first rotating groove and the second rotating groove are provided opposite to each other in a width direction of the rotation mechanism. The base includes a first stop surface, the first stop surface is located in the first rotating groove, and a plane in which the first stop surface is located intersects a width direction of the base. The first main swing arm includes a second stop surface, and a plane in which the second stop surface is located intersects the width direction of the base. The first main swing arm is mounted in the first rotating groove, the second stop surface faces the first rotating groove, and the first main swing arm is rotatable and slidable along the first rotating groove; and the second main swing arm is mounted in the second rotating groove, and the second main swing arm is rotatable and slidable along the second rotating groove.

When the first main swing arm is unfolded with respect to the base, the first stop surface and the second stop surface are disposed opposite to each other, in the width direction of the base, the first main swing arm and the base are stopped, and the first main swing arm and the second main swing arm are rotatable toward each other, to make the first main swing arm folded with respect to the second main swing arm.

In this embodiment, the first stop surface is disposed at the base, the second stop surface is disposed at the first main swing arm, and when the first main swing arm is unfolded with respect to the base, the second stop surface and the first stop surface are disposed opposite to each other, so that the first stop surface can keep the first main swing arm from moving toward the base in the width direction of the base, and a vacancy of the rotation mechanism in an unfolded state can be reduced or even avoided, thereby improving use experience of a user. In addition, a display can be kept from redundancy and arching, thereby extending the service life of the display.

The base further includes a third stop surface, the third stop surface is located in the second rotating groove, and a plane in which the third stop surface is located intersects the width direction of the base. The second main swing arm includes a fourth stop surface, and a plane in which the fourth stop surface is located intersects the width direction of the base. The second main swing arm is mounted in the second rotating groove, the fourth stop surface faces the second rotating groove, and the second main swing arm is rotatable and slidable along the second rotating groove. When the second main swing arm is unfolded with respect to the base, the third stop surface and the fourth stop surface are disposed opposite to each other, and in the width direction of the base, the second main swing arm and the base are stopped.

In this embodiment, the third stop surface is disposed at the base, the fourth stop surface is disposed at the second main swing arm, and when the second main swing arm is unfolded with respect to the base, the fourth stop surface and the third stop surface are disposed opposite to each other, so that the third stop surface can keep the second main swing arm from moving toward the base in the width direction of the base, and a vacancy of the rotation mechanism in the unfolded state can be further reduced or even avoided, thereby improving the use experience of the user.

In a possible implementation, when the first main swing arm is unfolded with respect to the base, the first stop surface and the second stop surface abut against each other, and abutting force directions between the first stop surface and the second stop surface are consistent with the width direction of the base. In a possible implementation, when the second main swing arm is unfolded with respect to the base, the fourth stop surface and the third stop surface abut against each other, and abutting force directions between the fourth stop surface and the third stop surface are consistent with the width direction of the base.

It should be noted that, when the rotation mechanism is in the unfolded state, the user may apply a force toward the base on a main swing arm during use. The force provides the main swing arm with a trend of moving toward the base in the width direction of the base. This trend is a vacancy when the rotation mechanism is in the unfolded state.

In this embodiment, directions of the first stop surface and the second stop surface are disposed perpendicular to the width direction of the base, to make the abutting force directions between the first stop surface and the second stop surface consistent with the width direction of the base, so that a stop force direction of the rotation mechanism is parallel to a direction of pressing a vacancy when the user uses a foldable electronic device, and the stop precision of the rotation mechanism can be improved, thereby improving the use experience of the user.

The first rotating groove includes a first inner wall, the first inner wall is disposed facing away from the second rotating groove, and the first inner wall includes the first stop surface. In a possible implementation, the base further includes a first guide rail, the first guide rail is fastened on the first inner wall and extends in a direction away from the second rotating groove, and the first guide rail is disposed side by side with the first stop surface. The first main swing arm includes a first end, the first main swing arm is provided with a first groove, an opening of the first groove is located in a top surface or a bottom surface of the first main swing arm, and the first groove penetrates the first end.

When the first main swing arm is mounted on the base, the first end faces the first rotating groove, at least a part of the first guide rail is located in the first groove, and the first main swing arm is rotatable and slidable in the first rotating groove along the first guide rail.

In this embodiment, the first guide rail is disposed at the base, the first groove is provided in the first main swing arm, and the first guide rail is mounted in the first groove, to make the first main swing arm rotatable with respect to the base along the first guide rail, so that the stability of the rotation of the first main swing arm can be improved, to keep the first main swing arm from deviating from a preset path during rotation, and a stop effect and stop precision between the second stop surface and the first stop surface can be improved.

In a possible implementation, in a length direction of the base, the first guide rail is disposed side by side with the first stop surface; and the opening of the first groove is located at a bottom surface of the first main swing arm, and the second stop surface is disposed on a side wall of the first groove and faces the first end. When the first main swing arm is mounted on the base, the first guide rail is located on a side of the first groove facing away from a top surface of the base, and a top surface of the first guide rail is opposite to and in contact with a bottom wall surface of the groove.

In this embodiment, the first guide rail is disposed side by side with the first stop surface in the length direction of the base, and the second stop surface is disposed on the side wall of the first groove, to make the first stop surface rotatable toward the second stop surface along a rotation path of the first main swing arm when the first main swing arm rotates with respect to the base along the first guide rail, so that the first stop surface can be kept from deviating from the second stop surface when the first main swing arm is unfolded with respect to the base, and the stop effect and the stop precision between the second stop surface and the first stop surface can be improved.

In a possible implementation, in a thickness direction of the base, the first guide rail is disposed side by side with the first stop surface, and the first guide rail is located on a side of the first stop surface close to a top surface of the base. The opening of the first groove is located at the top surface of the first main swing arm, and the second stop surface is disposed at the first end, and is connected between a bottom surface of the first main swing arm and a bottom wall surface of the first groove. When the first main swing arm is mounted on the base, the first guide rail is located on a side of the first groove close to the top surface of the base, and the bottom surface of the first guide rail is opposite to and in contact with a bottom wall surface of the groove.

In this embodiment, the second stop surface is disposed at an end portion of the first main swing arm, so that an area of the second stop surface can be increased, a contact area between the second stop surface and the first stop surface can be increased, to increase a stop area between the first main swing arm and the base, a stop effect and stop precision between the first main swing arm and the base can be further improved, and a vacancy of the rotation mechanism in the unfolded state can be further reduced or even avoided.

In a possible implementation, the first stop surface includes a first sub-stop surface, in a thickness direction of the base, the first sub-stop surface is disposed side by side with the first guide rail, and the first sub-stop surface is located on a side of the first guide rail close to a top surface of the base. The opening of the first groove is located at a bottom surface of the first main swing arm, the second stop surface includes a second sub-stop surface, and the second sub-stop surface is disposed at the first end, and is connected between the top surface of the first main swing arm and a bottom wall surface of the first groove.

When the first main swing arm is mounted on the base, the first guide rail is located on a side of the first groove facing away from the top surface of the base, and a top surface of the first guide rail is opposite to and in contact with the bottom wall surface of the first groove. When the first main swing arm is unfolded with respect to the base, the first sub-stop surface and the second sub-stop surface are disposed opposite to each other.

In this embodiment, the second sub-stop surface is disposed on the second stop surface, and the second sub-stop surface is disposed at the end portion of the first main swing arm, so that an area of the second sub-stop surface can be increased, a contact area between the second sub-stop surface and the first sub-stop surface can be increased, to increase the stop area between the first main swing arm and the base, the stop effect and the stop precision between the first main swing arm and the base can be further improved, and a vacancy of the rotation mechanism in the unfolded state can be further reduced or even avoided.

In a possible implementation, the first stop surface further includes a third sub-stop surface, and in a length direction of the base, the third sub-stop surface is disposed side by side with the first guide rail. The first main swing arm further includes a fourth sub-stop surface, and the fourth sub-stop surface is disposed on a side wall of the first groove and faces the first end. When the first main swing arm is unfolded with respect to the base, the third sub-stop surface and the fourth sub-stop surface are disposed opposite to each other.

In this embodiment, the third sub-stop surface is further disposed at the base, and the fourth sub-stop surface is further disposed at the first main swing arm, so that when the rotation mechanism is in the unfolded state, the first main swing arm and the base implement stop through the second sub-stop surface and the first sub-stop surface and further implement stop through the fourth sub-stop surface and the third sub-stop surface, the first main swing arm can be further kept from continuing to move toward the base in the width direction of the base, thereby further improving the stop effect and the stop precision, and a vacancy of the rotation mechanism in the unfolded state can be reduced or even avoided, thereby improving the use experience of the user.

In a possible implementation, the first stop surface includes a first sub-stop surface, and in a length direction of the base, the first guide rail is disposed side by side with the first sub-stop surface. The second stop surface includes a second sub-stop surface, and the second sub-stop surface is disposed at an end of the first main swing arm, and is connected between the top surface of the first main swing arm and a bottom surface of the first main swing arm. When the first main swing arm is unfolded with respect to the base, the first sub-stop surface and the second sub-stop surface are disposed opposite to each other.

In this embodiment, the second sub-stop surface is disposed on the second stop surface, and the second sub-stop surface is an end surface of the first main swing arm, so that the area of the second sub-stop surface can be further increased, the contact area between the second sub-stop surface and the first sub-stop surface can be increased, to increase the stop area between the first main swing arm and the base, the stop effect and the stop precision between the first main swing arm and the base can be further improved, and a vacancy of the rotation mechanism in the unfolded state can be further reduced or even avoided.

In a possible implementation, the first stop surface further includes a third sub-stop surface, in the length direction of the base, the third sub-stop surface is disposed side by side with the first stop surface and the first guide rail, and the third sub-stop surface is located between the first sub-stop surface and the first guide rail. The opening of the first groove is located at the bottom surface of the first main swing arm; and the second stop surface further includes a fourth sub-stop surface, and the fourth sub-stop surface is disposed on a side wall of the first groove and faces the first end. When the first main swing arm is mounted on the base, the first guide rail is located on a side of the first groove facing away from a top surface of the base, and a top surface of the first guide rail is opposite to and in contact with a bottom wall surface of the first groove. When the first main swing arm is unfolded with respect to the base, the third sub-stop surface and the fourth sub-stop surface are disposed opposite to each other.

In this embodiment, the third sub-stop surface is further disposed at the base, and the fourth sub-stop surface is further disposed at the first main swing arm, so that when the rotation mechanism is in the unfolded state, the first main swing arm and the base implement stop through the second sub-stop surface and the first sub-stop surface and further implement stop through the fourth sub-stop surface and the third sub-stop surface, the first main swing arm can be further kept from continuing to move toward the base in the width direction of the base, thereby further improving the stop effect and the stop precision, and a vacancy of the rotation mechanism in the unfolded state can be reduced or even avoided, thereby improving the use experience of the user.

In a possible implementation, the first stop surface and the second stop surface are in an interference fit.

It should be explained that, the "interference fit" is abutting against and pressing each other. In this embodiment, the first stop surface and the second stop surface are in an interference fit, to implement a force fit between the first stop surface and the second stop surface, so that the first main swing arm can be further kept from moving toward the base in the width direction of the base, and the stop precision of the rotation mechanism can be further improved, to reduce a vacancy of the rotation mechanism in the unfolded state, thereby improving the reliability of the display of the foldable electronic device, and improving the use experience of the user.

In a possible implementation, an interference amount between the first stop surface and the second stop surface ranges from 0 mm to 0.1 mm.

In a possible implementation, the rotation mechanism further includes a wear-resistant layer, and the wear-resistant layer is disposed on the first stop surface or/and the second stop surface.

In this embodiment, the wear-resistant layer is disposed on the stop surface, to improve the wear resistance of the stop surface, so that a stop effect between the first stop surface and the second stop surface can be improved, thereby extending the service life of the rotation mechanism, and improving the stop precision of the rotation mechanism in a full life cycle.

In a possible implementation, the rotation mechanism has a folded state and an unfolded state, when the rotation mechanism is switched from the unfolded state to the folded state, the first main swing arm rotates in a first direction, and when the rotation mechanism is in the unfolded state, the first main swing arm and the base are stopped in a second direction; and the second direction is opposite to the first direction.

In this embodiment, when the rotation mechanism is in the unfolded state, the first main swing arm and the base are stopped in the second direction, so that the foldable electronic device can be kept from being excessively unfolded, to avoid damage to the display.

In a possible implementation, the base includes a shaft cover and a support plate, and the shaft cover and the support plate are stacked and are fastened to each other. When the first main swing arm and the second main swing arm are unfolded with respect to each other, the top surface of the first main swing arm and a top surface of the second main swing arm are both flush with a surface of the support plate facing away from the shaft cover.

The top surface of the first main swing arm, the top surface of the second main swing arm, and a top surface of the support plate are jointly configured for supporting the display, so that the reliability of the display can be improved, thereby ensuring good display of the display.

According to a second aspect, this application provides a foldable electronic device. The foldable electronic device includes a first housing, a second housing, a display, and the foregoing rotation mechanism. The rotation mechanism is connected between the first housing and the second housing, and the display is mounted on the first housing, the second housing, and the rotation mechanism. When the rotation mechanism rotates, the first housing and the second housing rotate with respect to each other, to drive the display to bend or unfold.

A foldable electronic device with the foregoing rotation mechanism has a small vacancy or even no vacancy in an unfolded state, and a display is not prone to redundancy and arching.

In summary, for the rotation mechanism provided in this application, the first stop surface is disposed at the base, the second stop surface is disposed at the first main swing arm, and when the first main swing arm is unfolded with respect to the base, the second stop surface and the first stop surface are disposed opposite to each other, so that the second stop surface can keep the first main swing arm from moving toward the base in the width direction of the base, and a vacancy of the rotation mechanism in an unfolded state can be reduced or even avoided, thereby improving use experience of a user. In addition, a display can be kept from redundancy and arching, thereby extending the service life of the display, and a foldable electronic device can be kept from being excessively unfolded, to avoid damage to the display.

### BRIEF DESCRIPTION OF DRAWINGS

To describe technical solutions in embodiments or the background of this application more clearly, the following describes accompanying drawings required in the embodiments or the background of this application.
FIG. 1 is a schematic diagram of a structure of a foldable electronic device in a first state according to an embodiment of this application;
FIG. 2 is a schematic diagram of a structure of a foldable electronic device in a second state according to an embodiment of this application;
FIG. 3 is a schematic diagram of a structure of a foldable electronic device in a third state according to an embodiment of this application;
FIG. 4 is a schematic exploded view of a structure of the foldable electronic device shown in FIG. 3;
FIG. 5 is a schematic diagram of a structure of a rotation mechanism in the foldable electronic device shown in FIG. 4;
FIG. 6 is a schematic exploded view of a structure of the rotation mechanism shown in FIG. 5;
FIG. 7 is a partial schematic diagram of a structure of a base in the rotation mechanism shown in FIG. 5;
FIG. 8 is an enlarged schematic diagram of a structure of a main swing arm in the rotation mechanism shown in FIG. 6;
FIG. 9 is a schematic diagram of a structure of the main swing arm shown in FIG. 8 from another angle;
FIG. 10 is a partial schematic diagram of a structure of the rotation mechanism shown in FIG. 5;
FIG. 11 is a schematic cross-sectional view of a structure of the rotation mechanism shown in FIG. 10 in an A-A direction;
FIG. 12 is a partial schematic diagram of a structure of the rotation mechanism shown in FIG. 5 in a second implementation;
FIG. 13 is a schematic diagram of a structure of a bracket in the rotation mechanism shown in FIG. 12;
FIG. 14 is a schematic exploded view of a structure of the bracket shown in FIG. 13 from another angle;
FIG. 15 is an enlarged schematic diagram of a structure of a main swing arm in the rotation mechanism shown in FIG. 12;
FIG. 16 is an enlarged schematic diagram of a structure of the main swing arm shown in FIG. 15 from another angle;
FIG. 17 is a schematic cross-sectional view of a structure of the rotation mechanism shown in FIG. 12 in a B-B direction;
FIG. 18 is a partial schematic diagram of a structure of the rotation mechanism shown in FIG. 5 in a third implementation;
FIG. 19 is a schematic exploded view of a structure of the rotation mechanism shown in FIG. 18;
FIG. 20 is a schematic exploded view of a structure of the rotation mechanism shown in FIG. 18 from another angle;
FIG. 21 is a schematic cross-sectional view of a structure of the rotation mechanism shown in FIG. 18 in a C-C direction;
FIG. 22 is a partial schematic diagram of a structure of the rotation mechanism shown in FIG. 5 in a fourth implementation;
FIG. 23 is a schematic exploded view of a structure of the rotation mechanism shown in FIG. 22;
FIG. 24 is a schematic exploded view of a structure of the rotation mechanism shown in FIG. 22 from another angle;
FIG. 25 is a schematic cross-sectional view of a structure of the rotation mechanism shown in FIG. 22 in a D-D direction;
FIG. 26 is a schematic diagram of a structure of a fastened frame in a first rotation assembly of the rotation mechanism shown in FIG. 5;
FIG. 27 is a partial schematic diagram of a structure of a pressing plate in the rotation mechanism shown in FIG. 5; and
FIG. 28 is a partial schematic exploded view of a structure of the rotation mechanism shown in FIG. 6.

### DESCRIPTION OF EMBODIMENTS

Embodiments of this application are described below with reference to the accompanying drawings in the embodiments of this application.

With the development of science and technologies, an appearance (ID) form of an electronic device (for example, a mobile phone or a tablet computer) tends to develop from a bar-type machine to a foldable machine. The foldable electronic device has a large-area screen in an open state and therefore fully meets visual experience of a consumer; and has a small size in a closed state and therefore is easy to carry. A rotating shaft is a core component of the foldable electronic device, and a main swing arm in the rotating shaft supports the movement of a middle frame. In the related technology, when a foldable electronic device is in an unfolded state, a main swing arm has a vacancy, which may cause redundancy and arching of a display, affecting use experience of a user. A rotation mechanism provided in this application is provided with a stop mechanism, and can reduce a vacancy of a foldable electronic device in an unfolded state, thereby avoiding redundancy and arching of a display.

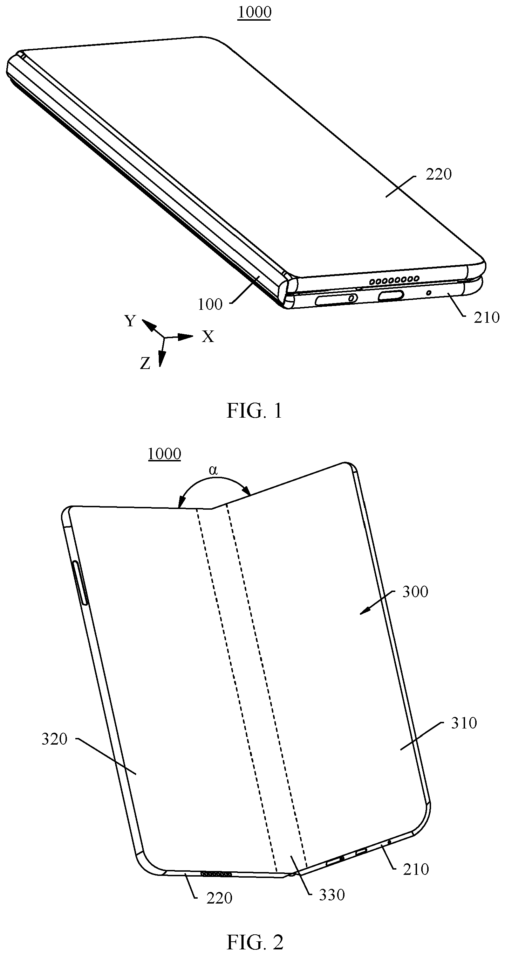

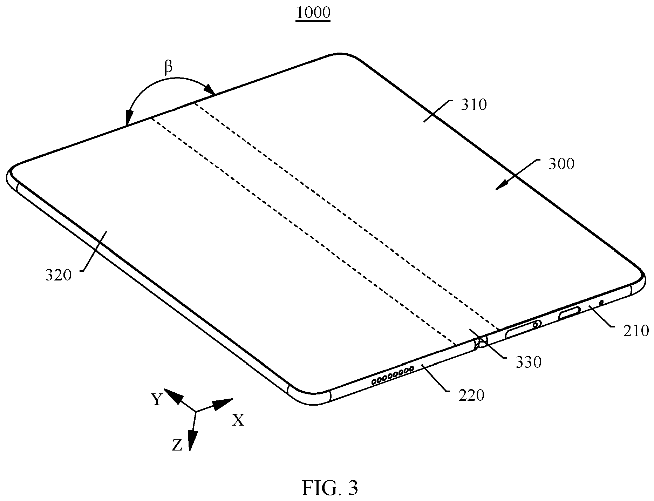

FIG. 1 is a schematic diagram of a structure of a foldable electronic device 1000 in a first state according to an embodiment of this application. FIG. 2 is a schematic diagram of a structure of the foldable electronic device 1000 in a second state according to an embodiment of this application. FIG. 3 is a schematic diagram of a structure of the foldable electronic device 1000 in a third state according to an embodiment of this application.

For ease of description, a width direction of the foldable electronic device 1000 is defined as an X direction, a length direction of the foldable electronic device 1000 is defined as a Y direction, and a thickness direction of the foldable electronic device 1000 is defined as a Z direction. The X direction, the Y direction, and the Z direction are perpendicular to each other.

The foldable electronic device 1000 includes, but is not limited to, a mobile phone (cellphone), a notebook computer (notebook computer), a tablet personal computer (tablet personal computer), a laptop computer (laptop computer), a personal digital assistant (personal digital assistant), a wearable device (wearable device), and an in-vehicle device (mobile device). In this embodiment of this application, an example in which the foldable electronic device 1000 is a mobile phone is used for description.

The foldable electronic device 1000 includes a folded state and an unfolded state. The unfolded state includes a half-unfolded state and a flattened state. The foldable electronic device 1000 shown in FIG. 1 is in the folded state, the foldable electronic device 1000 shown in FIG. 2 is in the half-unfolded state, and the foldable electronic device 1000 shown in FIG. 3 is in the flattened state. An unfolding angle α of the foldable electronic device 1000 shown in FIG. 2 is 90 degrees, and an unfolding angle β of the foldable electronic device 1000 shown in FIG. 3 is 180 degrees.

It should be noted that each angle described in this embodiment of this application is allowed to have a slight deviation. For example, that the unfolding angle α of the foldable electronic device 1000 shown in FIG. 2 is 90 degrees means that α may be 90 degrees, or may be approximately 90 degrees, for example, 80 degrees, 85 degrees, 95 degrees, or 0 degrees. That the unfolding angle β of the foldable electronic device 1000 shown in FIG. 3 is 180 degrees means that β may be 180 degrees, or may be approximately 180 degrees, for example, 170 degrees, 175 degrees, 185 degrees, or 190 degrees. Angles used as examples for description below can be understood identically.

The foldable electronic device 1000 shown in embodiments of this application is an electronic device that can fold once. In some other embodiments, the foldable electronic device 1000 may alternatively be an electronic device that can fold a plurality of times (at least two times). In this case, the foldable electronic device 1000 may include a plurality of parts, two adjacent parts can fold toward each other until the foldable electronic device 1000 is in the folded state, and two adjacent parts can unfold away from each other until the foldable electronic device 1000 is in the flattened state.

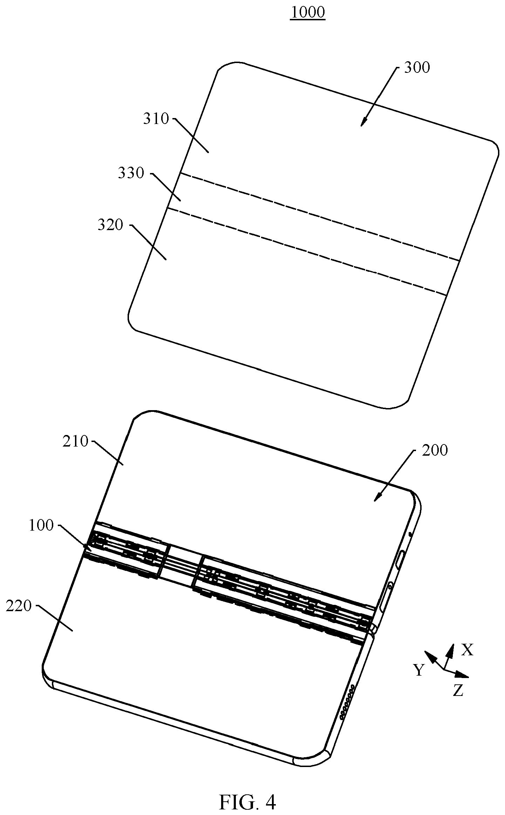

FIG. 4 is a schematic exploded view of a structure of the foldable electronic device 1000 shown in FIG. 3.

The foldable electronic device 1000 includes a foldable apparatus 200 and a display 300, and the display 300 is mounted on the foldable apparatus 200. The display 300 includes a display surface 340 and a mounting surface 350, and the display surface 340 is disposed opposite to the mounting surface 350. The display surface 340 is configured to display a text, an image, a video, and the like. The display 300 includes a first part 310, a second part 320, and a foldable part 330. The foldable part 330 is located between the first part 310 and the second part 320, and the foldable part 330 can bend in the Y direction. The first part 310, the second part 320, and the foldable part 330 jointly constitute the display 300. In this embodiment, the display 300 is a flexible display 300.

The foldable apparatus 200 includes a first housing 210, a second housing 220, and a rotation mechanism 100. The rotation mechanism 100 is partially fastened in the first housing 210 and partially fastened in the second housing 220, to implement a rotatable connection between the first housing 210 and the second housing 220. The display 300 is mounted on the foldable apparatus 200, and the mounting surface 350 is fastened to the foldable apparatus 200. Specifically, the first housing 210 bears the first part 310 of the display 300, and the second housing 220 bears the second part 320. In other words, the first part 310 is mounted on the first housing 210, and the second part 320 is mounted on the second housing 220. The rotation mechanism 100 and the foldable part 330 are disposed opposite to each other. The first housing 210 and the second housing 220 are rotatable with respect to each other through the rotation mechanism 100, so that the foldable apparatus 200 switches between the folded state and the flattened state.

With reference to FIG. 1, the first housing 210 and the second housing 220 rotate with respect to each other through the rotation mechanism 100, and the first housing 210 and the second housing 220 approach each other to drive the display 300 to fold, so that the foldable electronic device 1000 folds. When the foldable electronic device 1000 is in the folded state, the foldable part 330 of the display 300 bends, and the first part 310 is disposed opposite to the second part 320. In this case, the display 300 is located between the first housing 210 and the second housing 220, so that a probability that the display 300 is damaged can be greatly reduced, thereby effectively protecting the display 300.

With reference to FIG. 2 and FIG. 4 together, the first housing 210 and the second housing 220 rotate with respect to each other through the rotation mechanism 100, and the first housing 210 and the second housing 220 leave each other to drive the display 300 to unfold, so that the foldable electronic device 1000 unfolds to the half-unfolded state. When the foldable electronic device 1000 is in the half-unfolded state, the first housing 210 and the second housing 220 unfold to the angle α, and the first part 310 and the second part 320 unfold with respect to each other and drive the foldable part 330 to unfold. In this case, an angle between the first part 310 and the second part 320 is α. In this embodiment, α is 90 degrees. In other embodiments, α may alternatively be approximately 90 degrees, and may be 80 degrees, 85 degrees, 95 degrees, 0 degrees, or the like.

With reference to FIG. 3 and FIG. 4 together, the first housing 210 and the second housing 220 rotate with respect to each other through the rotation mechanism 100, and the first housing 210 and the second housing 220 leave each other to drive the display 300 to further unfold until the foldable electronic device 1000 flattens. When the foldable apparatus 200 is in the flattened state, the angle between the first housing 210 and the second housing 220 is β. The foldable part 330 unfolds, and the first part 310 and the second part 320 unfold with respect to each other. In this case, both angles between the first part 310 and the second part 320 and the foldable part 330 are β, and the display 300 has a large-area display region, to implement large-screen display of the foldable electronic device 1000, thereby improving use experience of a user. In this embodiment, β is 180 degrees. In other embodiments, β may alternatively be approximately 180 degrees, and may be 170 degrees, 175 degrees, 185 degrees, 190 degrees, or the like.

It should be noted that both the angle α and the angle β are angles between the first housing 210 and the second housing 220, and are merely used herein to distinguish between different angles between the first housing 210 and the second housing 220 in different states of the foldable electronic device 1000. The angle α is the angle between the first housing 210 and the second housing 220 in the half-unfolded state of the foldable electronic device 1000. The angle β is an angle between the first housing 210 and the second housing 220 in the flattened state of the foldable electronic device 1000.

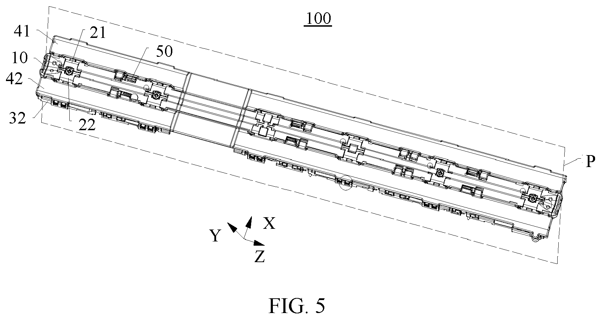

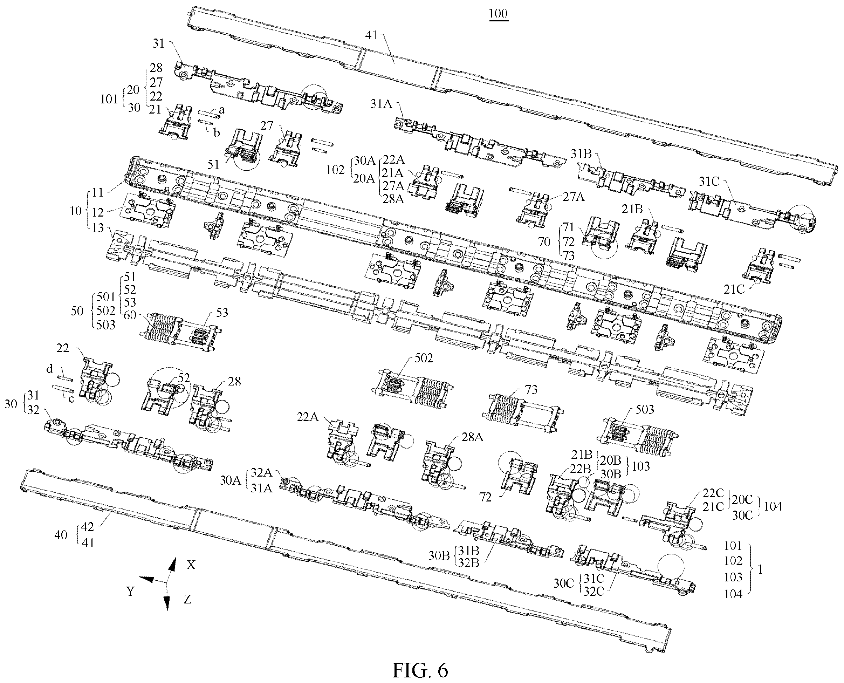

FIG. 5 is a schematic exploded view of a structure of the rotation mechanism 100 in the foldable electronic device 1000 shown in FIG. 4. FIG. 6 is a schematic diagram of an exploded structure of the rotation mechanism 100 shown in FIG. 5.

For ease of description, a reference plane P is provided in this application. The reference plane P passes through the center of the rotation mechanism 100, and is perpendicular to the X direction. It should be understood that orientation words such as "top" and "bottom" used in this embodiment of this application to describe the rotation mechanism 100 are mainly described based on a display orientation of the rotation mechanism 100 shown in FIG. 5, with the "top" facing a Z-axis negative direction and the "bottom" facing a Z-axis positive direction, which does not limit an orientation of the rotation mechanism 100 in an actual application scenario.

The rotation mechanism 100 includes a base 10, a rotation assembly 1, a synchronization assembly 50, and a pressing plate 40. The rotation assembly 1 and the synchronization assembly 50 are both mounted on the base 10, and are rotatable with respect to the base 10, and the synchronization assembly 50 is slidably connected to the rotation assembly 1. The pressing plate 40 is mounted on the rotation assembly 1, and is slidably connected to the rotation assembly 1. When rotating with respect to the base 10, the rotation assembly 1 drives the pressing plate 40 and the synchronization assembly 50 to rotate simultaneously with respect to the base 10, to implement switching of the rotation mechanism 100 between the folded state and the flattened state.

In this embodiment, there are four rotation assemblies 1, and the four rotation assemblies 1 are respectively a first rotation assembly 101, a second rotation assembly 102, a third rotation assembly 103, and a fourth rotation assembly 104. The first rotation assembly 101, the second rotation assembly 102, the third rotation assembly 103, and the fourth rotation assembly 104 are sequentially arranged apart in the Y direction. The first rotation assembly 101 is located on a side of a Y-axis positive direction of the base 10, and the fourth rotation assembly 104 is located on a side of a Y-axis negative direction of the base 10. The second rotation assembly 102 and the third rotation assembly 103 are located between the first rotation assembly 101 and the second rotation assembly 102. In other embodiments, one rotation assembly 1, two rotation assemblies 1, three rotation assemblies 1, or more than five rotation assemblies 1 may be alternatively provided. A quantity of rotation assemblies 1 is not specifically limited in this application.

The first rotation assembly 101 includes a fastened frame 30 and a main swing arm 20. The fastened frame 30 includes a first fastened frame 31 and a second fastened frame 32. The main swing arm 20 includes a first main swing arm 21, a second main swing arm 24, a third main swing arm 27, and a fourth main swing arm 28. The main swing arm 20 is mounted on the base 10, and is slidable and rotatable with respect to the base 10. The first fastened frame 31, the first main swing arm 21, and the third main swing arm 27 are located on one side of the base 10 in the X direction, and the first main swing arm 21 and the third main swing arm 27 are both rotatably connected to the first fastened frame 31. When rotating with respect to the base 10, the first fastened frame 31 drives the first main swing arm 21 and the third main swing arm 27 to slide and rotate with respect to the base 10. The second fastened frame 32, the second main swing arm 24, and the fourth main swing arm 28 are located on the other side of the base 10 in the X direction, and the second main swing arm 24 and the fourth main swing arm 28 are both rotatably connected to the second fastened frame 32. When rotating with respect to the base 10, the second fastened frame 32 drives the second main swing arm 24 and the fourth main swing arm 28 to slide and rotate with respect to the base 10.

The second rotation assembly 102 and the first rotation assembly 101 may be same or similar assemblies, symmetric or partially symmetric structures, or different structures. In this embodiment, a structure of the second rotation assembly 102 is the same as that of the first rotation assembly 101. The second rotation assembly 102 includes a fastened frame 30A and a main swing arm 20A. The fastened frame 30A includes a first fastened frame 31A and a second fastened frame 32A. The main swing arm 20A includes a first main swing arm 21A, a second main swing arm 24A, a third main swing arm 27A, and a fourth main swing arm 28A. For basic structures of components in the second rotation assembly 102, a connection relationship between the components, and a connection relationship between the component and a component outside the assembly, refer to the related design of the first rotation assembly 101. The second rotation assembly 102 and the first rotation assembly 101 may be the same or different in detailed structures or position arrangement of components.

The third rotation assembly 103 and the first rotation assembly 101 may be same or similar assemblies, symmetric or partially symmetric structures, or different structures. In this embodiment, the third rotation assembly 103 includes a fastened frame 30B and a main swing arm 20B. The fastened frame 30B includes a first fastened frame 31B and a second fastened frame 32B. The main swing arm 20B includes a first main swing arm 21B and a second main swing arm 24B. For basic structures of components in the third rotation assembly 103, a connection relationship between the components, and a connection relationship between the component and a component outside the assembly, refer to the related design of the first rotation assembly 101. In this embodiment, a difference between the third rotation assembly 103 and the first rotation assembly 101 lies in that two main swing arms 20B are provided in the third rotation assembly 103. In other words, the main swing arms 20B of the third rotation assembly 103 include the first main swing arm 21B and the second main swing arm 24B, but do not include the third main swing arm and the fourth main swing arm.

The fourth rotation assembly 104 and the first rotation assembly 101 may be same or similar assemblies, symmetric or partially symmetric structures, or different structures. In this embodiment, the fourth rotation assembly 104 includes a fastened frame 30C and a main swing arm 20C. The fastened frame 30C includes a first fastened frame 31C and a second fastened frame 32C. The main swing arm 20C includes a first main swing arm 21C and a second main swing arm 24C. For basic structures of components in the fourth rotation assembly 104, a connection relationship between the components, and a connection relationship between the component and a component outside the assembly, refer to the related design of the first rotation assembly 101. The fourth rotation assembly 104 and the first rotation assembly 101 may be the same or different in detailed structures or position arrangement of components. In this embodiment, a difference between the fourth rotation assembly 104 and the first rotation assembly 101 lies in that two main swing arms 20 are provided in the fourth rotation assembly 104. In other words, the main swing arms 20C of the fourth rotation assembly 104 include the first main swing arm 21C and the second main swing arm 24C, but do not include the third main swing arm and the fourth main swing arm. In addition, a structure of the first main swing arm 21C in the fourth rotation assembly 104 is slightly different from a structure of the first main swing arm 21 in the first rotation assembly 101.

It should be noted that in this embodiment, the first fastened frame and the second fastened frame in each of the four rotation assemblies 1 are separate structural members. In other words, in the four rotation assemblies 1, the first fastened frame has a split-type structure, and the second fastened frame has a split-type structure. In some other implementations, in the four rotation assemblies 1, the first fastened frames may alternatively be fastened to each other into one structural member, and the second fastened frames may be fastened to each other into one structural member. In other words, the first fastened frame 31 of the first rotation assembly 101, the first fastened frame 31A of the second rotation assembly 102, the first fastened frame 31B of the third rotation assembly 103, and the first fastened frame 31C of the fourth rotation assembly 104 are fastened to each other, and are one same structural member. The second fastened frame 32 of the first rotation assembly 101, the second fastened frame 32B of the second rotation assembly 102, the second fastened frame 32B of the third rotation assembly 103, and the second fastened frame 32C of the fourth rotation assembly 104 are fastened to each other, and are one same structural member.

The pressing plate 40 includes a first pressing plate 41 and a second pressing plate 42. The first pressing plate 41 is mounted on the first fastened frame, and is simultaneously rotatably and slidably connected to the first fastened frames 31, 31A, 31B, and 31C. In addition, the first pressing plate 41 is also simultaneously slidably and rotatably connected to the first main swing arms 21, 21A, 21B, and 21C and the third main swing arm 27. When rotating with respect to the base 10, the first fastened frames 31, 31A, 31B, and 31C drive the first pressing plate 41 to rotate with respect to the base 10, and rotate and slide with respect to the first fastened frame 31, and simultaneously rotate and slide with respect to the first main swing arms 21, 21A, 21B, and 21C. The second pressing plate 42 is mounted on the second fastened frame 32, and is simultaneously rotatably and slidably connected to the second fastened frames 32, 32A, 32B, and 32C. In addition, the second pressing plate 42 is also simultaneously slidably and rotatably connected to the second main swing arms 24, 24A, 24B, and 24C and the fourth main swing arm 28. When rotating with respect to the base 10, the second fastened frames 32, 32A, 32B, and 32C drive the second pressing plate 42 to rotate with respect to the base 10, and rotate and slide with respect to the second fastened frame 32, and simultaneously rotate and slide with respect to the second main swing arms 24, 24A, 24B, and 24C. It may be understood that, the main swing arm 20 in this embodiment is simultaneously connected to the fastened frame and the pressing plate, and the fastened frame 30 and the pressing plate 40 may jointly drive the main swing arm 20 to rotate with respect to the base 10. In other words, the main swing arm 20 in this embodiment also acts as a pressing plate swing arm.

In some other implementations, the main swing arm 20 may be not connected to the pressing plate 40. The rotation mechanism 100 further includes the pressing plate swing arm. One end of the pressing plate swing arm is mounted on the base 10, and is rotatably connected to the base 10, and the other end of the pressing plate swing arm is mounted on the pressing plate 40, and is rotatably and slidably connected to the pressing plate 40. When rotating with respect to the base 10, the pressing plate 40 drives the pressing plate swing arm to rotate with respect to the base 10. In other words, the pressing plate swing arm and the main swing arm 20 are two separately disposed swing arms.

The synchronization assembly 50 is mounted on the base 10 and is slidably connected to the fastened frame 30. In this embodiment, three synchronization assemblies 50 are provided. The four synchronization assemblies 50 are respectively a first synchronization assembly 501, a second synchronization assembly 502, and a third synchronization assembly 503. The first synchronization assembly 501 includes a first synchronization swing arm 51, a second synchronization swing arm 52, a synchronization gear 53, and a damping member 60. The first synchronization swing arm 51 and the second synchronization swing arm 52 are respectively disposed on two opposite sides of the synchronization gear 53 in the X direction, are engaged with the synchronization gear 53, and are also hinged to the damping member 60. The damping member 60 and the synchronization gear 53 are both mounted on the base 10, and are rotatable with respect to the base 10. The first synchronization swing arm 51 is located on the same side as the first main swing arm 21, is spaced apart from the first main swing arm 21 and the third main swing arm 27, and is slidably connected to the first fastened frame 31 in the first rotation assembly 101. The second synchronization swing arm 52 is located on the same side as the second main swing arm 24, is spaced apart from the second main swing arm 24 and the fourth main swing arm 28, and is slidably connected to the second fastened frame 32 in the first rotation assembly 101. When rotating with respect to the base 10, the first rotation assembly 101 drives the first synchronization swing arm 51 to rotate, to drive the synchronization gear 53 to rotate to drive the second synchronization swing arm 52 to rotate, thereby implementing the synchronous rotation of the rotation mechanism 100. In addition, when rotating with respect to the base 10, the first synchronization swing arm 51 and the second synchronization swing arm 52 abut against the damping member 60, so that the damping member 60 generates an elastic force, which in turn acts on the first synchronization swing arm 51 and the second synchronization swing arm 52 to provide a damping force to the rotation mechanism 100, thereby providing the user with a damping feel.

The second synchronization assembly 502, the third synchronization assembly 503, and the first synchronization assembly 501 may be same or similar assemblies, symmetric or partially symmetric structures, or different structures. In this embodiment, a structure of the second synchronization assembly 502 and a structure of the first synchronization assembly 501 are mirror-symmetric structures. The second synchronization assembly 502 is mounted on the base 10, and is slidably connected to the fastened frame 30A in the second rotation assembly 102. A structure of the third synchronization assembly 503 and a structure of the first synchronization assembly 501 are mirror-symmetric structures. The third synchronization assembly 503 is mounted on the base 10, and is slidably connected to the fastened frame 30C in the fourth rotation assembly 104.

It may be understood that the synchronization swing arms in the first synchronization assembly 501, the second synchronization assembly 502, and the third synchronization assembly 503 also act as damping swing arms. When the damping member 60 acts on the synchronization swing arms, the synchronization swing arms have a damping force.

In this embodiment, the rotation mechanism 100 further includes an auxiliary damping assembly 70. The auxiliary damping assembly 70 includes an auxiliary damping member 71, a first damping swing arm 72, and a second damping swing arm 73. The auxiliary damping member 71 and the damping member 60 have the same structure or similar structures. The auxiliary damping member 71 is mounted on the base 10. The first damping swing arm 72 and the second damping swing arm 73 are respectively disposed on two opposite sides of the auxiliary damping member 71 in the X direction, and are hinged to the auxiliary damping member 71. The first damping swing arm 72 is slidably connected to the first fastened frame 31B in the third rotation assembly 103. The second damping swing arm 73 is slidably connected to the second fastened frame 32B in the third rotation assembly 103. When rotating with respect to the base 10, the first fastened frame 31B drives the first damping swing arm 72 to rotate with respect to the base 10 and abut against the auxiliary damping member 71, to enable the auxiliary damping member 71 to generate an elastic force, which in turn acts on the first damping swing arm 72. When rotating with respect to the base 10, the second fastened frame 32B drives the second damping swing arm 73 to rotate with respect to the base 10 and abut against the auxiliary damping member 71, to enable the auxiliary damping member 71 to generate an elastic force, which in turn acts on the second damping swing arm 73, thereby further providing a damping force to the rotation mechanism 100.

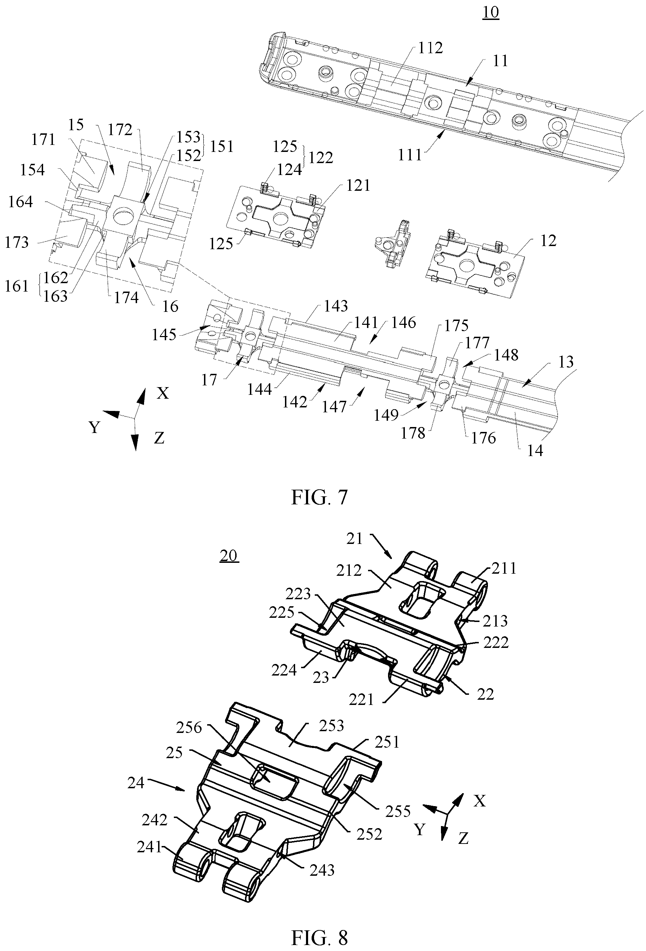

FIG. 7 is a partial schematic diagram of a structure of the base 10 in the rotation mechanism 100 shown in FIG. 5.

The base 10 is strip-shaped. A length direction of the base 10 is parallel to the Y direction. The base 10 includes a shaft cover 11, a bracket 12, and a support plate 13. The shaft cover 11, the bracket 12, and the support plate 13 are sequentially stacked, and are fastened to each other. The shaft cover 11 includes an outer surface 111 and an inner surface 112. The outer surface 111 and the inner surface 112 are disposed opposite to each other and are respectively located on two opposite sides of the shaft cover 11 in the thickness direction (the Z direction).

The bracket 12 includes a plate body 121 and a stopper 123. The stopper 123 includes a first stopper 124 and a second stopper 125. In this embodiment, a plurality of first stoppers 124 and a plurality of second stoppers 125 are provided. The plurality of first stoppers 124 are spaced apart in the Y direction on one side of the plate body 121 in the X direction. The plurality of second stoppers 125 are spaced apart in the Y direction on the other side of the plate body 121 in the X direction. In this embodiment, the bracket 12 includes a plurality of sub-brackets 12. The plurality of sub-brackets 12 are spaced apart on the inner surface 112 of the shaft cover 11 in the Y direction, and are fastened to the shaft cover 11. In other embodiments, the bracket 12 may have an integral structure.

The support plate 13 has a strip-shaped plate-like structure. The support plate 13 includes a support plate body 14 and a guide rail portion 17. The guide rail portion 17 is fastened to the support plate body 14. The guide rail portion 17 is configured for mounting the main swing arm 20, to enable the main swing arm 20 to slide and rotate along the guide rail portion 17.

The support plate body 14 includes a top surface 141, a bottom surface 142, a first side surface 143, and a second side surface 144. The top surface 141 and the bottom surface 142 are disposed opposite to each other, and are respectively located on two opposite sides in the Z direction. The first side surface 143 and the second side surface 144 are disposed opposite to each other, are respectively located on two opposite sides in the X direction, and are connected between the top surface 141 and the bottom surface 142. The top surface 141 is provided with an avoidance groove 145. The avoidance groove 145 is formed by the first side surface 143 and the second side surface 144 being bent and recessed toward a center of the top surface 141 in the X direction. The avoidance groove 145 is configured for avoiding the display 300. When the foldable electronic device 1000 is in the folded state, a bent part of the display 300 is at least partially located in the avoidance groove 145, to avoid adverse phenomena such as creases on the display 300 during bending, thereby extending the service life of the display 300.

The support plate body 14 is provided with a first notch 15 and a second notch 16. The first notch 15 and the second notch 16 are spaced apart and opposite to each other in the X direction. The first notch 15 is provided in the first side surface 143, and penetrates the top surface 141 and the bottom surface 142. The first notch 15 includes a first inner wall 151 and two second inner walls 154. The two second inner walls 154 are disposed opposite to each other in the Y direction, and the first inner wall 151 is connected between the two second inner walls 154. The first inner wall 151 includes a first arc surface 152 and a first stop surface 153. The first arc surface 152 includes two sub-arc surfaces. The two sub-arc surfaces are respectively located on two opposite sides of the first inner wall 151 in the Y direction. The first stop surface 153 is located between the two sub-arc surfaces of the first arc surface 152. The first stop surface 153 faces the first side surface 143. The first stop surface 153 is a flat surface, and a plane in which the first stop surface 153 is located is perpendicular to the X direction. In this embodiment, the first stop surface 153 is perpendicular to the X direction. The first stop surface 153 is configured for stopping the first main swing arm 21.

The second notch 16 and the first notch 15 are symmetrically provided with respect to the reference plane P. The second notch 16 is provided in the second side surface 144, and penetrates the top surface 141 and the bottom surface 142. The second notch 16 includes a third inner wall 161 and two fourth inner walls 164. The two fourth inner walls 164 are disposed opposite to each other in the Y direction, and the third inner wall 161 is connected between the two fourth inner walls 164. The third inner wall 161 includes a second arc surface 162 and a third stop surface 163. The third stop surface 163 is located between the two sub-arc surfaces of the second arc surface 162. The third stop surface 163 faces the second side surface 144. The third stop surface 163 is a flat surface, and a plane in which the third stop surface 163 is located is perpendicular to the X direction. In this embodiment, the third stop surface 163 is perpendicular to the X direction. The third stop surface 163 is configured for stopping the second main swing arm 24.

The guide rail portion 17 includes a first sliding rail 171 and a first guide rail 172. The first sliding rail 171 and the first guide rail 172 are both disposed on an inner wall of the first notch 15. In this embodiment, two first sliding rails 171 are provided. Each first sliding rail 171 is fastened on one second inner wall 154, and extends into the first notch 15. The two first sliding rails 171 are opposite to and spaced apart from each other in the Y direction. A top surface of the first sliding rail 171 and the top surface 141 are flush, and are configured for jointly supporting the display 300. A bottom surface of the first sliding rail 171 is arc-shaped, and is configured for matching the first main swing arm 21. One end of the first guide rail 172 is fastened to the first inner wall 151, and the other end of the first guide rail 172 extends toward the first side surface 143. In addition, the first stop surface 153 is located on two opposite sides of the first guide rail 172. A top surface of the first guide rail 172 is arc-shaped, and is configured for matching the first main swing arm 21.

The guide rail portion 17 further includes a second sliding rail 173 and a second guide rail 174. The second sliding rail 173 and the second guide rail 174 are both disposed on an inner wall of the second notch 16. In this embodiment, two second sliding rails 173 are provided. One second sliding rail 173 is fastened on one fourth inner wall 164, and extends into the second notch 16. The two second sliding rails 173 are opposite to and spaced apart from each other in the Y direction. A top surface of the second sliding rail 173 and the top surface 141 are flush, and are configured for jointly supporting the display 300. A bottom surface of the second sliding rail 173 is arc-shaped, and is configured for matching the second main swing arm 24. One end of the second guide rail 174 is fastened to the third inner wall 161, and the other end of the second guide rail 174 extends toward the second side surface 144. The top surface 141 of the second guide rail 174 is arc-shaped, and is configured for matching the second main swing arm 24.

The support plate body 14 is further provided with a first mounting opening 146, a second mounting opening 147, a third notch 148, and a fourth notch 149. The first mounting opening 146 and the second mounting opening 147 are symmetrically provided with respect to the reference plane P. The third notch 148 and the fourth notch 149 are symmetrically provided with respect to the reference plane P. In addition, the first mounting opening 146, the third notch 148, and the first notch 15 are side by side and spaced apart in the Y direction, and the second mounting opening 147, the fourth notch 149, and the second notch 16 are side by side and spaced apart in the Y direction. A structure of the third notch 148 is consistent with a structure of the first notch 15, and a structure of the fourth notch 149 is consistent with a structure of the second notch 16. The first mounting opening 146 is configured for mounting the first synchronization swing arm 51, and the second mounting opening 147 is configured for mounting the second synchronization swing arm 52.

The guide rail portion 17 further includes a third sliding rail 175, a fourth sliding rail 176, a third guide rail 177, and a fourth guide rail 178. A structure of the third sliding rail 175 is consistent with the structure of the first sliding rail 171. A structure of the third guide rail 177 is consistent with the structure of the first guide rail 172. The third sliding rail 175 and the third guide rail 177 are fastened on an inner wall of the third notch 148. A structure of the fourth sliding rail 176 is consistent with the structure of the second sliding rail 173. A structure of the fourth guide rail 178 is consistent with the structure of the second guide rail 174. The fourth sliding rail 176 and the fourth guide rail 178 are fastened on an inner wall of the fourth notch 149.

The bracket 12 is mounted on the inner surface 112 of the shaft cover 11. Three sub-brackets 12 of the bracket 12 are side by side and spaced apart in the Y direction. The support plate 13 is mounted on a surface of the bracket 12 facing away from the shaft cover 11, and is clamped between the first stopper 124 and the second stopper 125. The stopper 123 fastens the support plate 13, and can improve the structural stability of the support plate 13. The base 10 further includes a plurality of bolts. The bolts pass through the support plate 13 and the bracket 12, and are fastened to the shaft cover 11, to implement the fastening among the support plate 13, the bracket 12, and the shaft cover 11.

The inner wall of the first notch 15 and a first sub-bracket 12 surround to form a first rotating groove, and the first stop surface 153 is located in the first rotating groove. The first rotating groove is configured for mounting the first main swing arm 21, and the first main swing arm 21 is rotatable and slidable in the first rotating groove. The inner wall of the second notch 16 and the first sub-bracket 12 surround to form a second rotating groove, and the third stop surface 163 is located in the second rotating groove. The second rotating groove is configured for mounting the second main swing arm 24, and the second main swing arm 24 is rotatable and slidable in the second rotating groove. The first rotating groove and the second rotating groove are disposed opposite to each other in a width direction (the X direction) of the base 10. The inner wall of the third notch 148 and a third sub-bracket 12 surround to form a third rotating groove, and the third rotating groove is configured for mounting the third main swing arm 27. The inner wall of the fourth notch 149 and the third sub-bracket 12 surround to form the fourth rotating groove, and the fourth rotating groove is configured for mounting a fourth main swing arm 28.

It should be noted that FIG. 7 shows only a partial structure of the base 10 in the Y-axis positive direction. A structure of the base 10 in the Y-axis negative direction is the same as or similar to that in the Y-axis positive direction, and the structure of the base 10 in the Y-axis negative direction may be appropriately adjusted according to the structures of the second rotation assembly 102, the third rotation assembly 103, and the fourth rotation member.

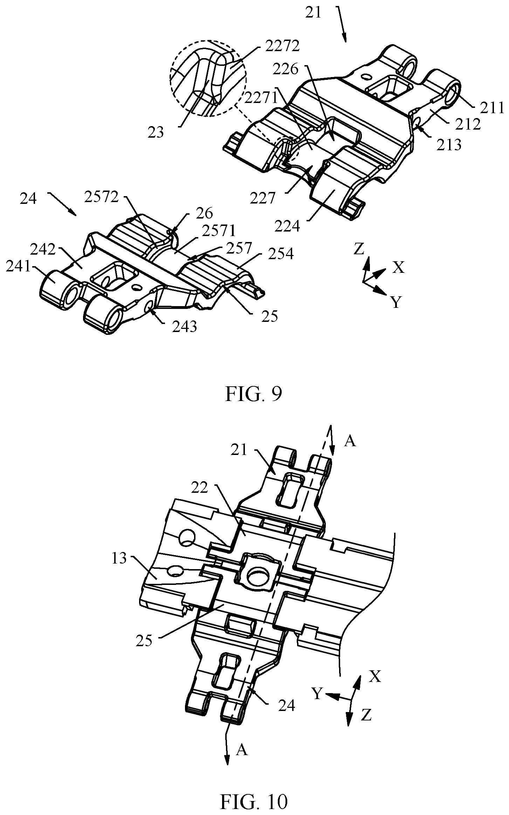

FIG. 8 is an enlarged schematic diagram of a structure of the main swing arm 20 in the rotation mechanism 100 shown in FIG. 6. FIG. 9 is a schematic diagram of a structure of the main swing arm 20 shown in FIG. 8 from another angle.

The main swing arm 20 includes the first main swing arm 21 and the second main swing arm 24. The first main swing arm 21 includes a first rotating body 22, a first swing body 212, and a first shaft seat 211. The first shaft seat 211 is provided with a shaft hole. An extension direction of the shaft hole of the first shaft seat 211 is parallel to the Y direction. The first shaft seat 211 is configured for being rotatably connected to the first main swing arm 21. The first swing body 212 is a planar plate. The first swing body 212 is provided with a first rotating hole 213. The first rotating hole 213 penetrates the first main swing arm 21 in a width direction (the Y direction) of the first main swing arm 21. An extension direction of the first rotating hole 213 is parallel to the Y direction. In other words, the extension direction of the first rotating hole 213 is consistent with an extension direction of the first shaft seat 211. The first swing body 212 is fastened between the first shaft seat 211 and the first rotating body 22.

The first rotating body 22 includes a first end 221 and a second end 222. The first end 221 and the second end 222 are disposed opposite to each other, and are respectively located on two opposite sides in the X direction. The second end 222 of the first rotating body 22 is fastened to an end of the first swing body 212 away from the first shaft seat 211. The first rotating body 22 includes a first support surface 223 and a first rotating surface 224. The first rotating surface 224 and the first support surface 223 are disposed opposite to each other in a thickness direction of the first main swing arm 21. The first rotating surface 224 is a curved surface, and is configured for being mounted in the first rotating groove. The first support surface 223 is a flat surface. When the first main swing arm 21 is unfolded with respect to the base 10, the first support surface 223 and the top surface 141 of the support plate 13 are approximately in the same plane, and are configured for jointly supporting the display 300. A first arc-shaped groove 225 is disposed on each of the two opposite sides of the first support surface 223 in the Y direction. The first arc-shaped groove 225 is configured for being slidably connected to the first sliding rail 171.

The first rotating body 22 is further provided with a first groove 227 and a first avoidance hole 226. An opening of the first groove 227 is located in the first rotating surface 224, and penetrates the first end 221. The first groove 227 includes a first bottom wall 2271 and two first side walls 2272. The two first side walls 2272 are disposed opposite to each other in the Y direction, and are both fastened to the first bottom wall 2271. The first bottom wall 2271 is arc-shaped, and is configured for being slidably connected to the first guide rail 172. The first side wall 2272 is provided with a step structure. The first main swing arm 21 further includes a second stop surface 23. The second stop surface 23 is located at a step structure of the first side surface 143. The second stop surface 23 faces the first end 221. The second stop surface 23 is a step surface of a step structure disposed on the first side wall 2272. A plane in which the second stop surface 23 is located is perpendicular to the X direction. The second stop surface 23 is configured for stopping the first stop surface 153. In this embodiment, the second stop surface 23 is perpendicular to the X direction. In some other implementations, an angle between the second stop surface 23 and the X direction may be slightly greater than 90 degrees, or slightly less than 90 degrees. The first avoidance hole 226 is provided in the first bottom wall 2271, and penetrates the first rotating body 22 in a thickness direction of the first rotating body 22. The first avoidance hole 226 is configured for avoiding the first guide rail 172.

A structure of the second main swing arm 24 is the same as the structure of the first main swing arm 21. The second main swing arm 24 includes a second rotating body 25, a second swing body 242, and a second shaft seat 241. The second swing body 242 is provided with a second rotating hole 243. The second swing body 242 is fastened between the second shaft seat 241 and the second rotating body 25. The second rotating body 25 includes a third end 251 and a fourth end 252. The fourth end 252 is fastened to an end of the second swing body 242 facing away from the second shaft seat 241.

The second rotating body 25 includes a second support surface 253 and a second rotating surface 254. When the second main swing arm 24 is unfolded with respect to the base 10, the second support surface 253 and the top surface 141 of the support plate 13 are approximately in the same plane, and are configured for jointly supporting the display 300. The second support surface 253 is provided with a second arc-shaped groove 255, a second groove 257, and a second avoidance hole 256. The second arc-shaped groove 255 is configured for being slidably connected to the second sliding rail 173. An opening of the second groove 257 is located in the second rotating surface 254, and penetrates the third end 251. The second groove 257 includes a second bottom wall 2571 and two second side walls 2572. The second bottom wall 2571 is configured for being slidably connected to the second guide rail 174. The second side wall 2572 is provided with a step structure. The second main swing arm 24 further includes a fourth stop surface 26. The fourth stop surface 26 is located at a step structure of the second side wall 2572. The fourth stop surface 26 faces the third end 251. The fourth stop surface 26 is a step surface of a step structure disposed on the second side wall 2572. The fourth stop surface 26 is configured for stopping the third stop surface 163.

With reference to FIG. 6, a structure of the third main swing arm 27 is the same as a structure of the first main swing arm 21, and a structure of the fourth main swing arm 28 is the same as a structure of the second main swing arm 24. Details are not described herein.

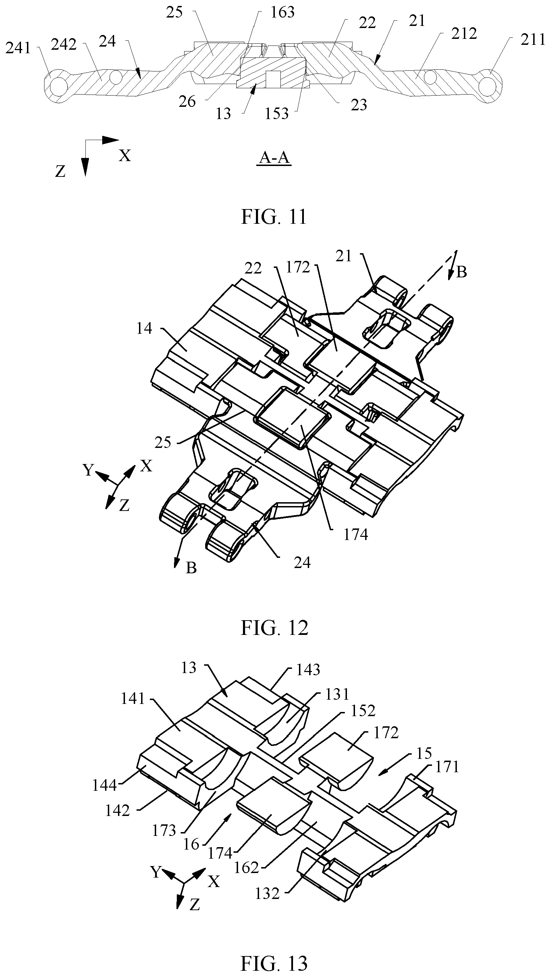

FIG. 10 is a partial schematic diagram of a structure of the rotation mechanism 100 shown in FIG. 5. FIG. 11 is a schematic cross-sectional view of a structure of the rotation mechanism 100 shown in FIG. 10 in an A-A direction. In the drawings of this application, "cross-section along A-A" is a cross-section along an A-A line and a plane in which arrows at two ends of the A-A line are located. Description of the drawings below can be understood identically.

The first main swing arm 21 and the second main swing arm 24 are both mounted on the base 10, and are respectively located on two opposite sides of the base 10 along an X axis. The first rotating body 22 of the first main swing arm 21 is mounted in the first rotating groove. The first rotating surface 224 faces the bracket 12. The first sliding rail 171 is located in the first arc-shaped groove 225, and the bottom surface of the first sliding rail 171 and a bottom wall of the first arc-shaped groove 225 are opposite and in contact. The first guide rail 172 is located in the first groove 227, the top surface of the first guide rail 172 and the first bottom wall 2271 of the first groove 227 are opposite and in contact, and two opposite side walls of the first guide rail 172 in the Y direction are respectively opposite to the two opposite first side walls 2272 of the first groove 227. When the first main swing arm 21 rotates with respect to the base 10, the first rotating body 22 is slidable and rotatable in the first rotating groove in extension directions of the first sliding rail 171 and the first guide rail 172.

The second rotating body 25 of the second main swing arm 24 is mounted in the second rotating groove. The second rotating surface 254 faces the bracket 12. The second sliding rail 173 is located in the second arc-shaped groove 255, and the bottom surface of the second sliding rail 173 and a bottom wall of the second arc-shaped groove 255 are opposite and in contact. The second guide rail 174 is located in the second groove 257, the top surface 141 of the second guide rail 174 and the second bottom wall 2571 of the second groove 257 are opposite and in contact, and two opposite side walls of the second guide rail 174 in the Y direction are respectively opposite to the two opposite second side walls 2572 of the second groove 257. When the second main swing arm 24 rotates with respect to the base 10, the second rotating body 25 is slidable and rotatable in the second rotating groove in extension directions of the second sliding rail 173 and the second guide rail 174.

Rotation directions of the first main swing arm 21 and the second main swing arm 24 with respect to the base 10 are opposite. For example, when the rotation mechanism 100 is switched from the folded state to the flattened state, the first main swing arm 21 rotates in a second direction, and the second main swing arm 24 rotates in a first direction. When the rotation mechanism 100 is switched from the flattened state to the folded state, the first main swing arm 21 rotates in the first direction, and the second main swing arm 24 rotates in the second direction. The first direction is opposite to the second direction. In this embodiment, the first direction is a counterclockwise direction, and the second direction is a clockwise direction.

When the rotation mechanism 100 is switched from the folded state to the flattened state, the first main swing arm 21 rotates clockwise, the first rotating surface 224 slides along the first arc surface 152 toward the first rotating groove, the bottom wall of the first arc-shaped groove 225 slides along the bottom surface of the first sliding rail 171 toward the first rotating groove, the first bottom wall 2271 of the first groove 227 slides along the top surface of the first guide rail 172 toward the first rotating groove, and the second stop surface 23 moves toward the first stop surface 153 for mutual stop. The second main swing arm 24 rotates counterclockwise, the second rotating surface 254 slides along the second arc surface 162 toward the second rotating groove, the bottom wall of the second arc-shaped groove 255 slides along the bottom surface of the second sliding rail 173 toward the second rotating groove, the second bottom wall 2571 of the second groove 257 slides along the top surface 141 of the second guide rail 174 toward the second rotating groove, and the fourth stop surface 26 moves toward the third stop surface 163 for mutual stop, to make the rotation mechanism 100 in the flattened state.

When the rotation mechanism 100 is in the flattened state, the first main swing arm 21 and the second main swing arm 24 are unfolded with respect to the base 10, an end of the first guide rail 172 facing away from the first inner wall 151 is located in the first avoidance hole 226, and an end of the second guide rail 174 facing away from the third inner wall 161 is located in the second avoidance hole 256. The first support surface 223, the second support surface 253, and the top surface 141 of the support plate 13 are approximately in the same plane, and are configured for jointly supporting the display 300. The second stop surface 23 and the first stop surface 153 are opposite and locked to each other, and the second stop surface 23 and the first stop surface 153 may be right in contact or may abut against each other. The fourth stop surface 26 and the third stop surface 163 are opposite and locked to each other, and the fourth stop surface 26 and the third stop surface 163 may be right in contact or may abut against each other.

When the rotation mechanism 100 is switched from the flattened state to the folded state, the first main swing arm 21 rotates counterclockwise, the first rotating body 22 rotates and slides along the first sliding rail 171 and the first guide rail 172 away from the first rotating groove, and the second stop surface 23 moves away from the first stop surface 153 and is unlocked from the first stop surface 153. The second main swing arm 24 rotates clockwise, the second rotating body 25 rotates and slides away from the second rotating groove along the second sliding rail 173 and the second guide rail 174, the fourth stop surface 26 moves away from the third stop surface 163 and is unlocked from the third stop surface 163, and the first main swing arm 21 and the second main swing arm 24 are folded with respect to each other, to make the rotation mechanism 100 in the folded state.

It should be noted that, when the rotation mechanism 100 is in the flattened state, the user applies a force toward the base 10 on the main swing arm 20 during use. The force provides the main swing arm 20 with a trend of moving toward the base 10 in the width direction (the X direction) of the base 10. This trend is a vacancy when the rotation mechanism 100 is in the flattened state. When the main swing arm 20 still has a movement space toward the base 10, the main swing arm 20 continues to move toward the base 10 in the X direction, i.e., the rotation mechanism 100 has a large vacancy, affecting the use experience of the user. In addition, after continuing to move toward the base 10 in the X direction, the main swing arm 20 presses the display 300, and as a result a redundancy, arching, or another phenomenon occurs in the display 300, causing damage to the display 300. The "redundancy" is a phenomenon that creases occur when the display 300 is pressed in directions from two opposite sides in the X direction toward the middle. "Arching" is that the display 300 is bent away from the base 10.

The first stop surface 153 is disposed in the first rotating groove, the second stop surface 23 is disposed at the first main swing arm 21. In this embodiment, when the rotation mechanism 100 is in the flattened state, the second stop surface 23 and the first stop surface 153 abut against each other, so that when the rotation mechanism 100 is in the flattened state, the second stop surface 23 can keep the first main swing arm 21 from moving toward the base 10 in the X direction, i.e., the first main swing arm 21 and the base 10 are stopped in the X direction, and a vacancy of the rotation mechanism 100 in the flattened state can be reduced or even avoided, thereby improving use experience of a user. In addition, the display 300 can be kept from redundancy and arching, thereby extending the service life of the display 300. In addition, when the rotation mechanism 100 is in the flattened state, the first main swing arm 21 and the base 10 are further stopped in the clockwise direction, so that the first main swing arm 21 can be kept from further rotating clockwise, and the foldable electronic device 1000 can be kept from being excessively unfolded, to avoid damage to the display 300.

In addition, in this embodiment, the third stop surface 163 is disposed in the second rotating groove, the fourth stop surface 26 is disposed on the second main swing arm 24, and when the rotation mechanism 100 is in the flattened state, the fourth stop surface 26 and the third stop surface 163 abut against each other, so that when the rotation mechanism 100 is in the flattened state, the second main swing arm 24 cannot move in the X direction toward the base 10, and a vacancy of the rotation mechanism 100 in the flattened state can be further reduced or even avoided, thereby improving the use experience of the user.

In this embodiment, directions of the first stop surface 153, the second stop surface 23, the third stop surface 163, and the fourth stop surface 26 are all perpendicular to the X direction, and an abutting force direction between the first stop surface 153 and the second stop surface 23 and an abutting force direction between the third stop surface 163 and the fourth stop surface 26 are both parallel or approximately parallel to a direction in which the user presses a vacancy. In other words, a stop force direction of the rotation mechanism 100 is parallel to a direction of pressing a vacancy when the user uses the foldable electronic device 1000, and the stop precision of the rotation mechanism 100 can be improved, thereby improving the use experience of the user. In addition, the rotation mechanism 100 in this embodiment implements stop through abutting between surfaces, so that a stop area can be increased, and stop precision of the rotation mechanism can be further improved, thereby improving the use experience of the user.

In addition, in this embodiment, a pressing force of the user on the rotation mechanism 100 may be transferred to the first stop surface 153 and the third stop surface 163. A counterforce of the base 10 on the first main swing arm 21 is located on the second stop surface 23, and a counterforce of the base 10 on the second main swing arm 24 is located on the fourth stop surface 26, to avoid a weak region of the main swing arm 20, and force bearing of the main swing arm 20 is optimized, so that the main swing arm 20 is kept from damage caused by the force of the base 10 on the main swing arm 20, thereby improving the reliability and the service life of the rotation mechanism 100.

In addition, in this embodiment, the first guide rail 172 is disposed at the base 10, the first groove 227 is provided in the first main swing arm 21, and the first guide rail 172 is mounted in the first groove 227, to make the first main swing arm 21 rotatable with respect to the base 10 along the first guide rail 172, so that the stability of the rotation of the first main swing arm 21 can be improved, to keep the first main swing arm 21 from deviating from a preset path during rotation, and a stop effect and stop precision between the second stop surface 23 and the first stop surface 153 can be improved. The second guide rail 174 is disposed at the base 10, the second groove 257 is provided in the second main swing arm 24, and the second guide rail 174 is mounted in the second groove 257, to make the second main swing arm 24 rotatable with respect to the base 10 along the second guide rail 174, so that the stability of the rotation of the second main swing arm 24 can be improved, to keep the second main swing arm 24 from deviating from a preset path during rotation, and a stop effect and stop precision between the fourth stop surface 26 and the third stop surface 163 can be improved.

In an implementation, when the rotation mechanism 100 is in the flattened state, the first stop surface 153 and the second stop surface 23 are in an interference fit. An interference amount between the first stop surface 153 and the second stop surface 23 ranges from 0 mm to 0.1 mm. In some implementations, the interference amount between the first stop surface 153 and the second stop surface 23 ranges from 0 mm to 0.04 mm. The "interference fit" is that the first stop surface 153 and the second stop surface 23 abut against and press each other. A deformation amount generated when the first stop surface 153 and the second stop surface 23 press each other is the interference amount. The "interference amount" is a sum of a deformation amount of the first stop surface 153 and a deformation amount of the second stop surface 23. In this embodiment, the first stop surface 153 and the second stop surface 23 are in an interference fit, to implement a force fit between the first stop surface 153 and the second stop surface 23, so that the first main swing arm 21 can be further kept from moving toward the base 10 in the X direction, and the stop precision of the rotation mechanism 100 can be further improved, to reduce a vacancy of the rotation mechanism 100 in the flattened state, thereby improving the reliability of the display 300 of the foldable electronic device 1000, and improving the use experience of the user.

When the rotation mechanism 100 is in the flattened state, the third stop surface 163 and the fourth stop surface 26 are in an interference fit. An interference amount between the third stop surface 163 and the fourth stop surface 26 ranges from 0 mm to 0.1 mm. In some implementations, the interference amount between the third stop surface 163 and the fourth stop surface 26 ranges from 0 mm to 0.04 mm. The "interference amount" is a sum of a deformation amount of the third stop surface 163 and a deformation amount of the fourth stop surface 26. In this embodiment, the third stop surface 163 and the fourth stop surface 26 are in an interference fit, to implement a force fit between the third stop surface 163 and the fourth stop surface 26, so that the second main swing arm 24 can be further kept from moving toward the base 10 in the X direction, and a vacancy of the rotation mechanism 100 in the flattened state can be further reduced, thereby improving the use experience of the user.

In an implementation, the rotation mechanism 100 includes a wear-resistant layer. The wear-resistant layer may be made of a metal material, or may be made of a polymer material. For example, the wear-resistant layer is made of polytetrafluoroethylene. In this embodiment, the first stop surface 153, the second stop surface 23, the third stop surface 163, and the fourth stop surface 26 are all provided with wear-resistant layers. The wear-resistant layer is formed by using a physical vapor deposition method. In other implementations, the wear-resistant layer may be formed by using another coating process. In this embodiment, the wear-resistant layer is disposed on the stop surface, to improve the wear resistance of the stop surface, so that a stop effect between the first stop surface 153 and the second stop surface 23 and a stop effect between the third stop surface 163 and the fourth stop surface 26 can be improved, thereby extending the service life of the rotation mechanism 100, and improving the stop precision of the rotation mechanism 100 in a full life cycle.

In some other implementations, the wear-resistant layer may be disposed on one stop surface in the first stop surface 153, the second stop surface 23, the third stop surface 163, and the fourth stop surface 26. Alternatively, the wear-resistant layer may be disposed on two stop surfaces or three stop surfaces in the first stop surface 153, the second stop surface 23, the third stop surface 163, and the fourth stop surface 26.

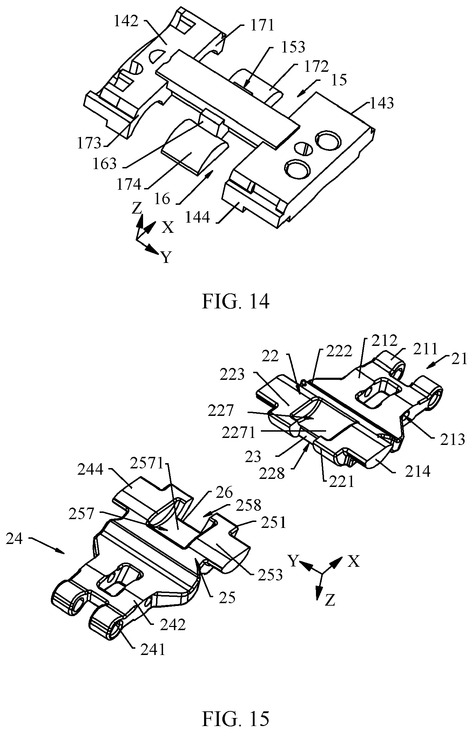

FIG. 12 is a partial schematic diagram of a structure of the rotation mechanism 100 shown in FIG. 5 in a second implementation. FIG. 13 is a schematic diagram of a structure of the bracket 12 in the rotation mechanism 100 shown in FIG. 12. FIG. 14 is a schematic exploded view of a structure of the bracket 12 shown in FIG. 13 from another angle.

A difference between the base 10 in the rotation mechanism 100 in this embodiment and the base 10 shown in FIG. 7 lies in:

In this embodiment, the first stop surface 153 of the support plate 13 is located between the two sub-arc surfaces of the first arc surface 152, and faces the first side surface 143. The first stop surface 153 and the first guide rail 172 are disposed side by side in the Z direction, and the first stop surface 153 is located on a side of a Z-axis positive direction of the first guide rail 172. The top surface of the first guide rail 172 is a flat surface, and the top surface and the top surface 141 of the bracket 12 are flush, and are configured for jointly supporting the display 300. A bottom surface of the first guide rail 172 is arc-shaped, and is configured for matching the first main swing arm 21. In addition, the bottom surface of the first guide rail 172 is connected to the first stop surface 153. The bottom surface of the first sliding rail 171 is a flat surface, and is flush with the bottom surface 142 of the bracket 12. Alternatively, a small height difference may exist between the bottom surface of the first sliding rail 171 and the bottom surface 142 of the support plate 13. The top surface of the first sliding rail 171 is arc-shaped, and forms a first sliding groove 131. The first sliding groove 131 is configured for mounting the first main swing arm 21.

The third stop surface 163 is located between the two sub-arc surfaces of the second arc surface 162, and faces the second side surface 144. The third stop surface 163 and the second guide rail 174 are disposed side by side in the Z direction, and the third stop surface 163 is located on a side of a Z-axis positive direction of the second guide rail 174. A top surface of the second guide rail 174 is a flat surface, and the top surface and the top surface 141 of the bracket 12 are flush, and are configured for jointly supporting the display 300. A bottom surface of the second guide rail 174 is arc-shaped, and is configured for matching the second main swing arm 24. In addition, the bottom surface of the second guide rail 174 is connected to the third stop surface 163. The bottom surface of the second sliding rail 173 is a flat surface, and is flush with the bottom surface 142 of the bracket 12. The top surface of the second sliding rail 173 is arc-shaped, and forms a second sliding groove 132. The second sliding groove 132 is configured for mounting the second main swing arm 24.

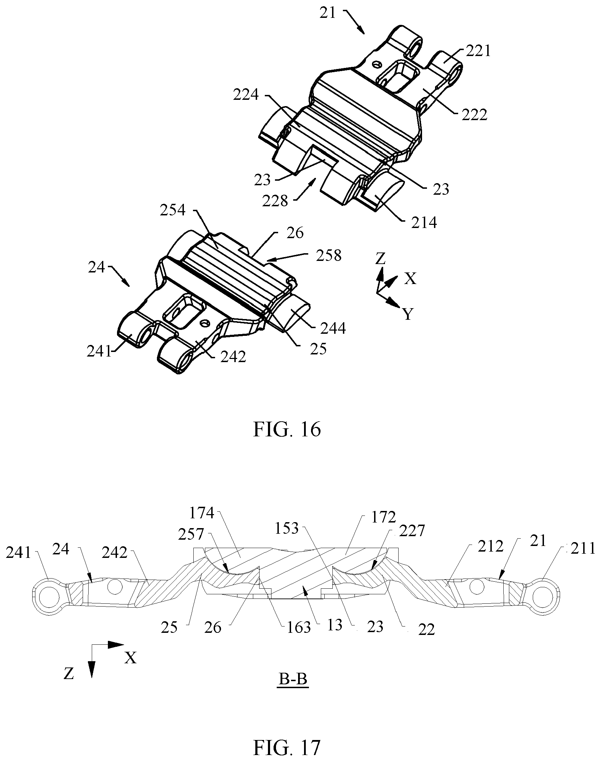

FIG. 15 is an enlarged schematic diagram of a structure of the main swing arm 20 in the rotation mechanism 100 shown in FIG. 12. FIG. 16 is an enlarged schematic diagram of a structure of the main swing arm 20 shown in FIG. 15 from another angle.

A difference between the main swing arm 20 in the rotation mechanism 100 in this embodiment and the main swing arm 20 shown in FIG. 8 lies in:

In this embodiment, the first main swing arm 21 further includes a first slider 214. Two first sliders 214 are provided. The two first sliders 214 are respectively fastened on two opposite sides of the first rotating body 22 in the Y direction. A top surface of the first slider 214 and the first support surface 223 are flush, and are configured for jointly supporting the display 300. A bottom surface of the first slider 214 is arc-shaped, and is configured for matching the first sliding rail 171. A first avoidance notch 228 is provided at the first end 221. The first avoidance notch 228 penetrates the first support surface 223 and the first rotating surface 224. The second stop surface 23 is disposed at a bottom surface of the first avoidance notch 228, and faces the first end 221. In this embodiment, the second stop surface 23 is perpendicular to the X direction. In some other implementations, the angle between the second stop surface 23 and the X direction may be slightly greater than 90 degrees, or slightly less than 90 degrees. It may be understood that the second stop surface 23 is a bottom wall surface of the first avoidance notch 228. The second stop surface 23 is configured for stopping the first stop surface 153. The first rotating body 22 is provided with the first groove 227. The opening of the first groove 227 is located in the first support surface 223, and is in communication with the first avoidance notch 228. The first bottom wall 2271 of the first groove 227 is arc-shaped. The first bottom wall 2271 is connected to the second stop surface 23. The first groove 227 is configured for mounting the first guide rail 172.

In this embodiment, the second main swing arm 24 further includes two second sliders 244. The two second sliders 244 are respectively fastened on two opposite sides of the second rotating body 25 in the Y direction. A top surface of the second slider 244 and the second support surface 253 are flush, and are configured for jointly supporting the display 300. A bottom surface of the second slider 244 is arc-shaped, and is configured for matching the second sliding rail 173. A second avoidance notch 258 is provided at the third end 251. The second avoidance notch 258 penetrates the second support surface 253 and the second rotating surface 254. The second avoidance notch 258 includes the fourth stop surface 26. The fourth stop surface 26 faces the third end 251. The fourth stop surface 26 is configured for stopping the third stop surface 163. The second rotating body 25 is provided with the second groove 257. The opening of the second groove 257 is located in the second support surface 253, and is in communication with the second avoidance notch 258. The second bottom wall 2571 of the second groove 257 is arc-shaped. The second bottom wall 2571 is connected to the fourth stop surface 26. The second groove 257 is configured for mounting the second guide rail 174.

FIG. 17 is a schematic cross-sectional view of a structure of the rotation mechanism 100 shown in FIG. 12 in a B-B direction.

The first main swing arm 21 and the second main swing arm 24 are both mounted on the base 10, and are respectively located on two opposite sides of the base 10 along the X axis. The first rotating body 22 of the first main swing arm 21 is mounted in the first rotating groove. The first rotating surface 224 faces the first inner wall 151, and is slidable along the first arc surface 152 of the first inner wall 151. The first slider 214 is located in the first sliding groove 131, and is slidable along the first sliding groove 131. The first guide rail 172 is located in the first groove 227, and the bottom surface of the first guide rail 172 and the first bottom wall 2271 of the first groove 227 are opposite and in contact. When the first main swing arm 21 rotates with respect to the base 10, the first rotating body 22 is slidable and rotatable in the first rotating groove in the extension directions of the first sliding rail 171 and the first guide rail 172.

The second rotating body 25 of the second main swing arm 24 is mounted in the second rotating groove. The second rotating surface 254 faces the third inner wall 161, and is slidable along the second arc surface 162 of the third inner wall 161. The second slider 244 is located in the second sliding groove 132, and is slidable along the second sliding groove 132. The second guide rail 174 is located in the second groove 257, and the bottom surface of the second guide rail 174 and the second bottom wall 2571 of the second groove 257 are opposite and in contact. When the second main swing arm 24 rotates with respect to the base 10, the second rotating body 25 is slidable and rotatable in the second rotating groove in the extension directions of the second sliding rail 173 and the second guide rail 174.

When the rotation mechanism 100 is switched from the folded state to the flattened state, the first main swing arm 21 rotates clockwise, the first rotating surface 224 slides along the first arc surface 152 toward the first rotating groove, the first slider 214 slides along the first sliding groove 131 toward the first rotating groove, the first bottom wall 2271 of the first groove 227 slides along the bottom surface of the first guide rail 172 toward the first guide rail 172, and the second stop surface 23 moves toward the first stop surface 153 for mutual stop with the first stop surface 153. The second main swing arm 24 rotates counterclockwise, the second rotating surface 254 slides along the second arc surface 162 toward the second rotating groove, the second slider 244 slides along the second sliding groove 132 toward the second rotating groove, the second bottom wall 2571 of the second groove 257 slides along the bottom surface of the second guide rail 174 toward the second guide rail 174, and the fourth stop surface 26 moves toward the third stop surface 163 for mutual stop with the third stop surface 163, to make the rotation mechanism 100 in the flattened state.

When the rotation mechanism 100 is in the flattened state, the first main swing arm 21 and the second main swing arm 24 are unfolded with respect to each other, the first slider 214 is located in the first sliding groove 131, the first guide rail 172 is located in the first groove 227, the second slider 244 is located in the first sliding groove 131, and the second guide rail 174 is located in the second groove 257. The first support surface 223, the top surface of the first guide rail 172, the second support surface 253, the top surface of the second guide rail 174, and the top surface 141 of the support plate 13 are approximately in the same plane, and are configured for jointly supporting the display 300. The second stop surface 23 and the first stop surface 153 are opposite and locked to each other, and the second stop surface 23 and the first stop surface 153 may be right in contact or may abut against each other. The fourth stop surface 26 and the third stop surface 163 are opposite and locked to each other, and the fourth stop surface 26 and the third stop surface 163 may be right in contact or may abut against each other.

In this embodiment, the first stop surface 153 is disposed in the first rotating groove, the second stop surface 23 is disposed at the first main swing arm 21, and when the rotation mechanism 100 is in the flattened state, the second stop surface 23 and the first stop surface 153 abut against each other, so that when the rotation mechanism 100 is in the flattened state, the second stop surface 23 can keep the first main swing arm 21 from moving toward the base 10 in the X direction, and a vacancy of the rotation mechanism 100 in the flattened state can be reduced or even avoided, thereby improving use experience of a user. In addition, the display 300 can be kept from redundancy and arching, thereby extending the service life of the display 300, and the foldable electronic device 1000 can be further kept from being excessively unfolded, to avoid damage to the display 300.

In addition, in this embodiment, the second stop surface 23 is disposed at an end portion of the first main swing arm 21, so that an area of the second stop surface 23 can be increased, a contact area between the second stop surface 23 and the first stop surface 153 can be increased, to increase a stop area between the first main swing arm 21 and the base 10, a stop effect and stop precision between the first main swing arm 21 and the base 10 can be further improved, and a vacancy of the rotation mechanism 100 in the flattened state can be further reduced or even avoided.

In addition, in this embodiment, the third stop surface 163 is disposed in the second rotating groove, the fourth stop surface 26 is disposed on the second main swing arm 24, and when the rotation mechanism 100 is in the flattened state, the fourth stop surface 26 and the third stop surface 163 abut against each other, so that when the rotation mechanism 100 is in the flattened state, the second main swing arm 24 cannot continue to move in the X direction toward the base 10, and a vacancy of the rotation mechanism 100 in the flattened state can be further reduced or even avoided, thereby improving the use experience of the user.

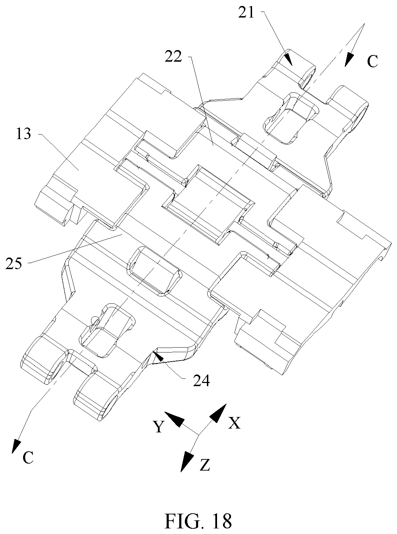

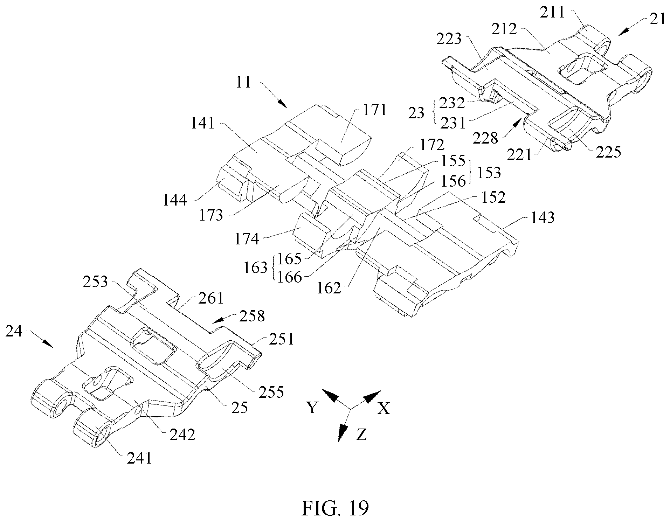

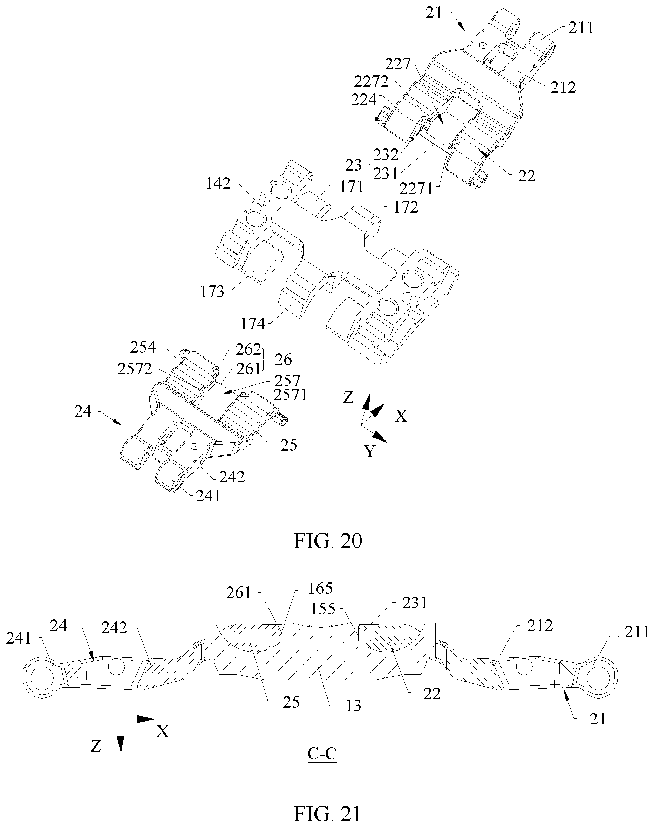

FIG. 18 is a partial schematic diagram of a structure of the rotation mechanism 100 shown in FIG. 5 in a third implementation. FIG. 19 is a schematic exploded view of a structure of the rotation mechanism 100 shown in FIG. 18. FIG. 20 is a schematic exploded view of a structure of the rotation mechanism 100 shown in FIG. 18 from another angle.

A difference between the base 10 in the rotation mechanism 100 in this embodiment and the base 10 shown in FIG. 7 lies in:

In this embodiment, the first inner wall 151 of the support plate 13 includes the first arc surface 152 and the first stop surface 153. The first stop surface 153 includes a first sub-stop surface 155 and a third sub-stop surface 156. The first arc surface 152 includes two sub-arc surfaces. The two sub-arc surfaces are respectively located on two opposite sides of the first inner wall 151 in the Y direction. The third sub-stop surface 156 and the first sub-stop surface 155 are both connected between the two sub-arc surfaces of the first arc surface 152. The third sub-stop surface 156 and the first sub-stop surface 155 are disposed side by side in the Z direction. In addition, the first sub-stop surface 155 is located on a side of a Z-axis negative direction of the third sub-stop surface 156. The third sub-stop surface 156 and the first sub-stop surface 155 are both flat surfaces, and face the first side surface 143. A plane in which the first sub-stop surface 155 is located and a plane in which the third sub-stop surface 156 is located both intersect the X direction. In this embodiment, the first sub-stop surface 155 and the third stop surface 163 are both perpendicular to the X direction. A height difference exists between the top surface of the first guide rail 172 and the top surface 141 of the bracket 12, and the top surface of the first guide rail 172 is located in a Z-axis positive direction of the top surface 141. The first sub-stop surface 155 is connected between the top surface 141 and the top surface of the first guide rail 172. The third sub-stop surface 156 is located on two opposite sides of the first guide rail 172 in the Y direction, and is fastened to a side of the first guide rail 172 in the Y direction.

In this embodiment, the second inner wall 154 further includes the second arc surface 162 and the third stop surface 163. The third stop surface 163 includes a fifth sub-stop surface 165 and a seventh sub-stop surface 166. The second arc surface 162 includes two sub-arc surfaces. The two sub-arc surfaces of the second arc surface 162 are respectively located on two opposite sides of the second inner wall 154 in the Y direction. The seventh sub-stop surface 166 and the fifth sub-stop surface 165 are both connected between the two sub-arc surfaces of the second arc surface 162. The seventh sub-stop surface 166 and the fifth sub-stop surface 165 are disposed side by side in the Z direction. In addition, the fifth sub-stop surface 165 is located on a side of a Z-axis negative direction of the seventh sub-stop surface 166. The seventh sub-stop surface 166 and the fifth sub-stop surface 165 are both flat surfaces, and face the second side surface 144. A plane in which the seventh sub-stop surface 166 is located and a plane in which the fifth sub-stop surface 165 is located are perpendicular to the X direction. A height difference exists between the top surface of the second guide rail 174 and the top surface 141 of the bracket 12, and the top surface of the second guide rail 174 is located in the Z-axis positive direction of the top surface 141. The fifth sub-stop surface 165 is connected between the top surface 141 and the top surface of the second guide rail 174. The seventh sub-stop surface 166 is located on two opposite sides of the second guide rail 174 in the Y direction, and is fastened to a side of the second guide rail 174 in the Y direction.

A difference between the main swing arm 20 of the rotation mechanism 100 in this embodiment and the main swing arm 20 shown in FIG. 8 lies in:

In this embodiment, the first avoidance notch 228 is provided at the first end 221 of the first main swing arm 21. The first avoidance notch 228 penetrates the first support surface 223 and the first rotating surface 224. The second stop surface 23 includes a second sub-stop surface 231 and a fourth sub-stop surface 232. The second sub-stop surface 231 is disposed on the bottom wall surface of the first avoidance notch 228. The second sub-stop surface 231 faces the first end 221. In this embodiment, the second sub-stop surface 231 is perpendicular to the X direction. It may be understood that the second sub-stop surface 231 is the bottom wall surface of the first avoidance notch 228. The opening of the first groove 227 is located in the first rotating surface 224, and is in communication with the first avoidance notch 228. The fourth sub-stop surface 232 is disposed on the first side wall 2272 of the first groove 227, and faces the first end 221. A structure of the fourth sub-stop surface 232 in this embodiment is the same as a structure of the second stop surface 23 in the embodiment shown in FIG. 8. The first bottom wall 2271 of the first groove 227 is arc-shaped. The first bottom wall 2271 is connected to the second sub-stop surface 231. In other words, the second sub-stop surface 231 is connected between the first bottom wall 2271 and the first support surface 223. The second sub-stop surface 231 is configured for stopping the first sub-stop surface 155 disposed in the first rotating groove.

In this embodiment, the second avoidance notch 258 is provided at the third end 251 of the second main swing arm 24. The second avoidance notch 258 penetrates the second support surface 253 and the second rotating surface 254. The fourth stop surface 26 includes a sixth sub-stop surface 261 and an eighth sub-stop surface 262. The sixth sub-stop surface 261 is disposed on a bottom wall surface of the second avoidance notch 258. The sixth sub-stop surface 261 faces the third end 251. In this embodiment, the sixth sub-stop surface 261 is perpendicular to the X direction. The opening of the second groove 257 is located in the second rotating surface 254, and is in communication with the second avoidance notch 258. The eighth sub-stop surface 262 is disposed on the second side wall 2572 of the second groove 257, and faces the third end 251. A structure of the eighth sub-stop surface 262 in this embodiment is the same as a structure of the fourth stop surface 26 in the embodiment shown in FIG. 8. The second bottom wall 2571 of the second groove 257 is arc-shaped. The second bottom wall 2571 is connected to the sixth sub-stop surface 261. In other words, the sixth sub-stop surface 261 is connected between the second bottom wall 2571 and the second support surface 253. The sixth sub-stop surface 261 is configured for stopping the fifth sub-stop surface 165 disposed in the second rotating groove.

FIG. 21 is a schematic cross-sectional view of a structure of the rotation mechanism 100 shown in FIG. 18 in a C-C direction.

The first main swing arm 21 and the second main swing arm 24 are both mounted on the base 10, and are respectively located on two opposite sides of the base 10 along the X axis. The first rotating body 22 of the first main swing arm 21 is mounted in the first rotating groove. The first rotating surface 224 faces the bracket 12. The first sliding rail 171 is located in the first arc-shaped groove 225, and the bottom surface of the first sliding rail 171 and the bottom wall of the first arc-shaped groove 225 are opposite and in contact. The first guide rail 172 is located in the first groove 227, the top surface of the first guide rail 172 and the first bottom wall 2271 of the first groove 227 are opposite and in contact, and the two opposite side walls of the first guide rail 172 in the Y direction are respectively opposite to the two opposite first side walls 2272 of the first groove 227. When the first main swing arm 21 rotates with respect to the base 10, the first rotating body 22 is slidable and rotatable in the first rotating groove in the extension directions of the first sliding rail 171 and the first guide rail 172.

The second rotating body 25 of the second main swing arm 24 is mounted in the second rotating groove. The second rotating surface 254 faces the bracket 12. The second sliding rail 173 is located in the second arc-shaped groove 255, and the bottom surface of the second sliding rail 173 and the bottom wall of the second arc-shaped groove 255 are opposite and in contact. The second guide rail 174 is located in the second groove 257, the top surface of the second guide rail 174 and the second bottom wall 2571 of the second groove 257 are opposite and in contact, and two opposite side walls of the second guide rail 174 in the Y direction are respectively opposite to the two opposite second side walls 2572 of the second groove 257. When the second main swing arm 24 rotates with respect to the base 10, the second rotating body 25 is slidable and rotatable in the second rotating groove in the extension directions of the second sliding rail 173 and the second guide rail 174.

When the rotation mechanism 100 is switched from the folded state to the flattened state, the first main swing arm 21 rotates clockwise, the first rotating surface 224 slides along the first arc surface 152 toward the first rotating groove, the bottom wall of the first arc-shaped groove 225 slides along the bottom surface of the first sliding rail 171 toward the first rotating groove, the first bottom wall 2271 of the first groove 227 slides along the top surface of the first guide rail 172 toward the first guide rail 172, the fourth sub-stop surface 232 moves toward the third sub-stop surface 156 for mutual stop, and the second sub-stop surface 231 moves toward the first sub-stop surface 155 for mutual stop. The second main swing arm 24 rotates counterclockwise, the second rotating surface 254 slides along the second arc surface 162 toward the second rotating groove, the bottom wall of the second arc-shaped groove 255 slides along the bottom surface of the second sliding rail 173 toward the second rotating groove, the second bottom wall 2571 of the second groove 257 slides along the top surface 141 of the second guide rail 174 toward the second guide rail 174, the eighth sub-stop surface 262 moves toward the seventh sub-stop surface 166 for mutual stop, and the sixth sub-stop surface 261 moves toward the fifth sub-stop surface 165 for mutual stop, to make the rotation mechanism 100 in the flattened state.

When the rotation mechanism 100 is in the flattened state, the first main swing arm 21 and the second main swing arm 24 are unfolded with respect to each other, the end of the first guide rail 172 facing away from the first inner wall 151 is located in the first avoidance hole 226, and the end of the second guide rail 174 facing away from the third inner wall 161 is located in the second avoidance hole 256. The first support surface 223, the second support surface 253, and the top surface 141 of the support plate 13 are approximately in the same plane, and are configured for jointly supporting the display 300. The fourth sub-stop surface 232 and the third sub-stop surface 156 are opposite and locked to each other, and the fourth sub-stop surface 232 and the third sub-stop surface 156 may be right in contact or may abut against each other. The second sub-stop surface 231 and the first sub-stop surface 155 are opposite and locked to each other, and the second sub-stop surface 231 and the first sub-stop surface 155 may be right in contact or may abut against each other. The eighth sub-stop surface 262 and the seventh sub-stop surface 166 are opposite and locked to each other, and the eighth sub-stop surface 262 and the seventh sub-stop surface 166 may be right in contact or may abut against each other. The sixth sub-stop surface 261 and the fifth sub-stop surface 165 are opposite and locked to each other, and the sixth sub-stop surface 261 and the fifth sub-stop surface 165 may be right in contact or may abut against each other.

In this embodiment, the first sub-stop surface 155 is disposed at the support plate 13, and the second sub-stop surface 231 is disposed at the first main swing arm 21, so that when the rotation mechanism 100 is in the flattened state, the first main swing arm 21 and the base 10 implement stop through the fourth sub-stop surface 232 and the third sub-stop surface 156 and further implement stop through the second sub-stop surface 231 and the first sub-stop surface 155, the first main swing arm 21 can be further kept from continuing to move toward the base 10 in the X direction, thereby improving the stop effect and the stop precision, and a vacancy of the rotation mechanism 100 in the flattened state can be reduced or even avoided, thereby improving use experience of a user. In addition, the display 300 can be further kept from redundancy and arching, thereby extending the service life of the display 300, and the foldable electronic device 1000 can be kept from being excessively unfolded, to avoid damage to the display 300.

In addition, in this embodiment, the fifth sub-stop surface 165 is disposed at the support plate 13, and the sixth sub-stop surface 261 is disposed at the second main swing arm 24, so that when the rotation mechanism 100 is in the flattened state, the second main swing arm 24 and the base 10 implement stop through the seventh sub-stop surface 166 and the eighth sub-stop surface 262 and further implement stop through the fifth sub-stop surface 165 and the sixth sub-stop surface 261, the second main swing arm 24 can be further kept from continuing to move toward the base 10 in the X direction, thereby improving the stop effect and the stop precision, and a vacancy of the rotation mechanism 100 in the flattened state can further be reduced or even avoided, thereby improving the use experience of the user.

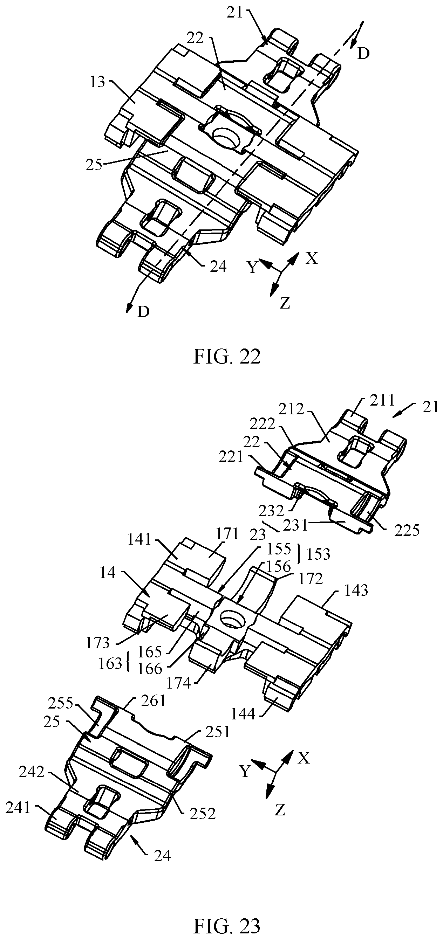

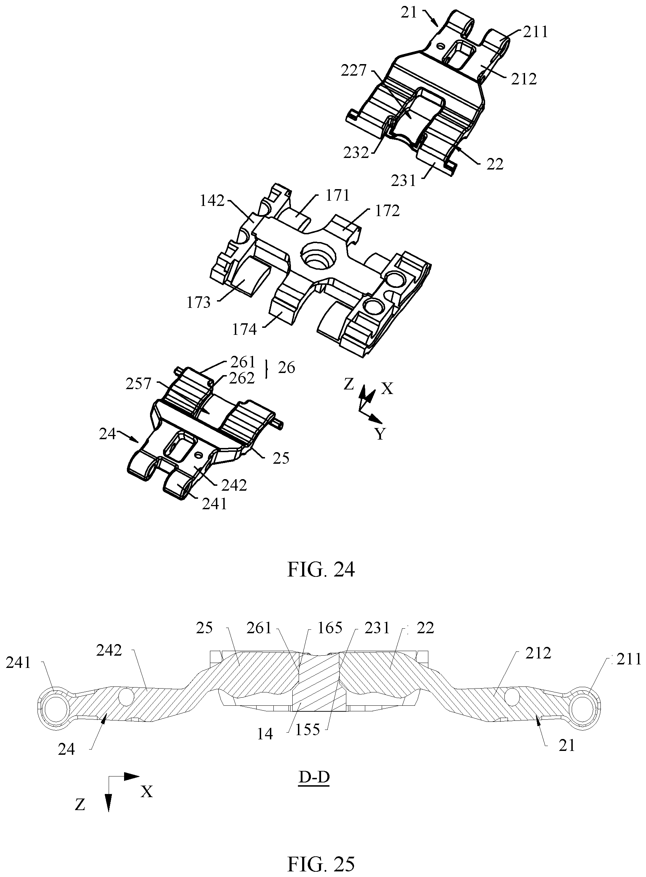

FIG. 22 is a partial schematic diagram of a structure of the rotation mechanism 100 shown in FIG. 5 in a fourth implementation. FIG. 23 is a schematic exploded view of a structure of the rotation mechanism 100 shown in FIG. 22. FIG. 24 is a schematic exploded view of a structure of the rotation mechanism 100 shown in FIG. 22 from another angle.

A difference between the base 10 in the rotation mechanism 100 in this embodiment and the base 10 shown in FIG. 7 lies in:

In this embodiment, the first inner wall 151 of the support plate 13 includes the first stop surface 153. The first stop surface 153 includes the third sub-stop surface 156 and the first sub-stop surface 155. The first sub-stop surface 155 includes two parts. The two parts of the first sub-stop surface 155 are respectively located on two opposite sides of the first inner wall 151 in the Y direction. The third sub-stop surface 156 is connected between the two parts of the first sub-stop surface 155. The third sub-stop surface 156 and the first sub-stop surface 155 are both flat surfaces, and both face the first side surface 143. Planes in which the first sub-stop surface 155 and the third sub-stop surface 156 are located both intersect the X direction. In this embodiment, the first sub-stop surface 155 and the third sub-stop surface 156 are both perpendicular to the X direction.

In this embodiment, the second inner wall 154 includes the third stop surface 163. The third stop surface 163 includes the seventh sub-stop surface 166 and the fifth sub-stop surface 165. The fifth sub-stop surface 165 includes two parts. The two parts of the fifth sub-stop surface 165 are respectively located on two opposite sides of the second inner wall 154 in the Y direction. The seventh sub-stop surface 166 is connected between the two parts of the fifth sub-stop surface 165. The seventh sub-stop surface 166 and the fifth sub-stop surface 165 are both flat surfaces, and both face the second side surface 144. Planes in which the fifth sub-stop surface 165 and the seventh sub-stop surface 166 are located both intersect the X direction. In this embodiment, the fifth sub-stop surface 165 and the seventh sub-stop surface 166 are both perpendicular to the X direction.

A difference between the main swing arm 20 of the rotation mechanism 100 in this embodiment and the main swing arm 20 shown in FIG. 8 lies in:

In this embodiment, the second stop surface 23 includes the second sub-stop surface 231 and the fourth sub-stop surface 232. The second sub-stop surface 231 is disposed on a side of the first end 221 facing away from the second end 222. The second sub-stop surface 231 is a flat surface, and a plane in which the second sub-stop surface 231 is located is perpendicular to the X direction. It may be understood that the second sub-stop surface 231 is an end surface of the first rotating body 22 in an X-axis negative direction. The fourth sub-stop surface 232 is disposed on the first side wall 2272 of the first groove 227, and faces the first end 221. A structure of the fourth sub-stop surface 232 in this embodiment is the same as a structure of the second stop surface 23 in the embodiment shown in FIG. 8. An orientation of the second sub-stop surface 231 is the same as an orientation of the fourth sub-stop surface 232. The second sub-stop surface 231 is configured for stopping the first sub-stop surface 155, and the fourth sub-stop surface 232 is configured for stopping the third sub-stop surface 156. In other words, the second sub-stop surface 231 and the fourth sub-stop surface 232 are jointly configured for abutting against the base 10.

In this embodiment, the fourth stop surface 26 of the second main swing arm 24 includes the sixth sub-stop surface 261 and the eighth sub-stop surface 262. The sixth sub-stop surface 261 is disposed on the bottom wall surface of the second avoidance notch 258. The sixth sub-stop surface 261 is disposed on a side of the second end 222 facing away from the second end 222. The sixth sub-stop surface 261 is a flat surface, and a plane in which the sixth sub-stop surface 261 is located is perpendicular to the X direction. It may be understood that the sixth sub-stop surface 261 is an end surface of the second rotating body 25 in the X-axis negative direction. The eighth sub-stop surface 262 is disposed on the second side wall 2572 of the second groove 257, and faces the third end 251. A structure of the eighth sub-stop surface 262 in this embodiment is the same as a structure of the fourth stop surface 26 in the embodiment shown in FIG. 8. An orientation of the sixth sub-stop surface 261 is the same as an orientation of the eighth sub-stop surface 262. The sixth sub-stop surface 261 is configured for stopping the fifth sub-stop surface 165, and the eighth sub-stop surface 262 is configured for stopping the seventh sub-stop surface 166. In other words, the sixth sub-stop surface 261 and the eighth sub-stop surface 262 are jointly configured for abutting against the base 10.

FIG. 25 is a schematic cross-sectional view of a structure of the rotation mechanism 100 shown in FIG. 22 in a D-D direction.

The first main swing arm 21 and the second main swing arm 24 are both mounted on the base 10, and are respectively located on two opposite sides of the base 10 along the X axis. The first rotating body 22 of the first main swing arm 21 is mounted in the first rotating groove. The first rotating surface 224 faces the bracket 12. The first sliding rail 171 is located in the first arc-shaped groove 225, and the bottom surface of the first sliding rail 171 and the bottom wall of the first arc-shaped groove 225 are opposite and in contact. The first guide rail 172 is located in the first groove 227, the top surface of the first guide rail 172 and the first bottom wall 2271 of the first groove 227 are opposite and in contact, and the two opposite side walls of the first guide rail 172 in the Y direction respectively face the two opposite first side walls 2272 of the first groove 227. When the first main swing arm 21 rotates with respect to the base 10, the first rotating body 22 is slidable and rotatable in the first rotating groove in the extension directions of the first sliding rail 171 and the first guide rail 172.

The second rotating body 25 of the second main swing arm 24 is mounted in the second rotating groove. The second rotating surface 254 faces the bracket 12. The second sliding rail 173 is located in the second arc-shaped groove 255, and the bottom surface of the second sliding rail 173 and the bottom wall of the second arc-shaped groove 255 are opposite and in contact. The second guide rail 174 is located in the second groove 257, the top surface of the second guide rail 174 and the second bottom wall 2571 of the second groove 257 are opposite and in contact, and two opposite side walls of the second guide rail 174 in the Y direction respectively face the two opposite second side walls 2572 of the second groove 257. When the second main swing arm 24 rotates with respect to the base 10, the second rotating body 25 is slidable and rotatable in the second rotating groove in the extension directions of the second sliding rail 173 and the second guide rail 174.

When the rotation mechanism 100 is switched from the folded state to the flattened state, the first main swing arm 21 rotates clockwise, the bottom wall of the first arc-shaped groove 225 slides along the bottom surface of the first sliding rail 171 toward the first rotating groove, the first bottom wall 2271 of the first groove 227 slides along the top surface of the first guide rail 172 toward the first guide rail 172, the fourth sub-stop surface 232 moves toward the third sub-stop surface 156 for mutual stop, and the second sub-stop surface 231 moves toward the first sub-stop surface 155 for mutual stop. The second main swing arm 24 rotates counterclockwise, the bottom wall of the second arc-shaped groove 255 slides along the bottom surface of the second sliding rail 173 toward the second rotating groove, the second bottom wall 2571 of the second groove 257 slides along the top surface 141 of the second guide rail 174 toward the second guide rail 174, the eighth sub-stop surface 262 moves toward the seventh sub-stop surface 166 for mutual stop, and the sixth sub-stop surface 261 moves toward the fifth sub-stop surface 165 for mutual stop, to make the rotation mechanism 100 in the flattened state.

When the rotation mechanism 100 is in the flattened state, the end of the first guide rail 172 facing away from the first inner wall 151 is located in the first avoidance hole 226, and the end of the second guide rail 174 facing away from the third inner wall 161 is located in the second avoidance hole 256. The first support surface 223, the second support surface 253, and the top surface 141 of the support plate 13 are approximately in the same plane, and are configured for jointly supporting the display 300. The fourth sub-stop surface 232 and the third sub-stop surface 156 are opposite and locked to each other, and the fourth sub-stop surface 232 and the third sub-stop surface 156 may be right in contact or may abut against each other. The second sub-stop surface 231 and the first sub-stop surface 155 are opposite and locked to each other, and the second sub-stop surface 231 and the first sub-stop surface 155 may be right in contact or may abut against each other. The eighth sub-stop surface 262 and the seventh sub-stop surface 166 are opposite and locked to each other, and the eighth sub-stop surface 262 and the seventh sub-stop surface 166 may be right in contact or may abut against each other. The sixth sub-stop surface 261 and the fifth sub-stop surface 165 are opposite and locked to each other, and the sixth sub-stop surface 261 and the fifth sub-stop surface 165 may be right in contact or may abut against each other.

In this embodiment, the first sub-stop surface 155 is disposed at the support plate 13, and the second sub-stop surface 231 is disposed at the first main swing arm 21, so that when the rotation mechanism 100 is in the flattened state, the first main swing arm 21 and the support plate 13 implement stop through the third sub-stop surface 156 and the fourth sub-stop surface 232 and further implement stop through the first sub-stop surface 155 and the second sub-stop surface 231, the first main swing arm 21 can be further kept from continuing to move toward the base 10 in the X direction, thereby improving the stop effect and the stop precision, and a vacancy of the rotation mechanism 100 in the flattened state can be reduced or even avoided, thereby improving use experience of a user. In addition, the display 300 can be further kept from redundancy and arching, thereby extending the service life of the display 300, and the foldable electronic device 1000 can be kept from being excessively unfolded, to avoid damage to the display 300.

In addition, in this embodiment, the fifth sub-stop surface 165 is disposed at the support plate 13, and the sixth sub-stop surface 261 is disposed at the second main swing arm 24, so that when the rotation mechanism 100 is in the flattened state, the second main swing arm 24 and the support plate 13 implement stop through the seventh sub-stop surface 166 and the eighth sub-stop surface 262 and further implement stop through the fifth sub-stop surface 165 and the sixth sub-stop surface 261, the second main swing arm 24 can be further kept from continuing to move toward the base 10 in the X direction, thereby improving the stop effect and the stop precision, and a vacancy of the rotation mechanism 100 in the flattened state can further be reduced or even avoided, thereby improving the use experience of the user.

In addition, in this embodiment, the first sub-stop surface 155 is disposed at an end surface of the first main swing arm 21, so that an area of the first sub-stop surface 155 can be increased, to increase a stop area between the first main swing arm 21 and the support plate 13, a stop effect and stop precision between the first main swing arm 21 and the support plate 13 can be further improved, and a vacancy of the rotation mechanism 100 in the flattened state can be further reduced or even avoided.

In this embodiment, the fifth sub-stop surface 165 is disposed at an end surface of the second main swing arm 24, so that an area of the fifth sub-stop surface 165 can be increased, to increase a stop area between the second main swing arm 24 and the support plate 13, a stop effect and stop precision between the second main swing arm 24 and the support plate 13 can be further improved, and a vacancy of the rotation mechanism 100 in the flattened state can be further reduced or even avoided.

It should be noted that, a structure of the main swing arm 20 in any rotation assembly 1 in the rotation mechanism 100 shown in FIG. 5 may be the same as a structure of any main swing arm 20 in the foregoing four implementations, and a structure of the support plate 13 may be adjusted according to a structure of the used main swing arm 20.

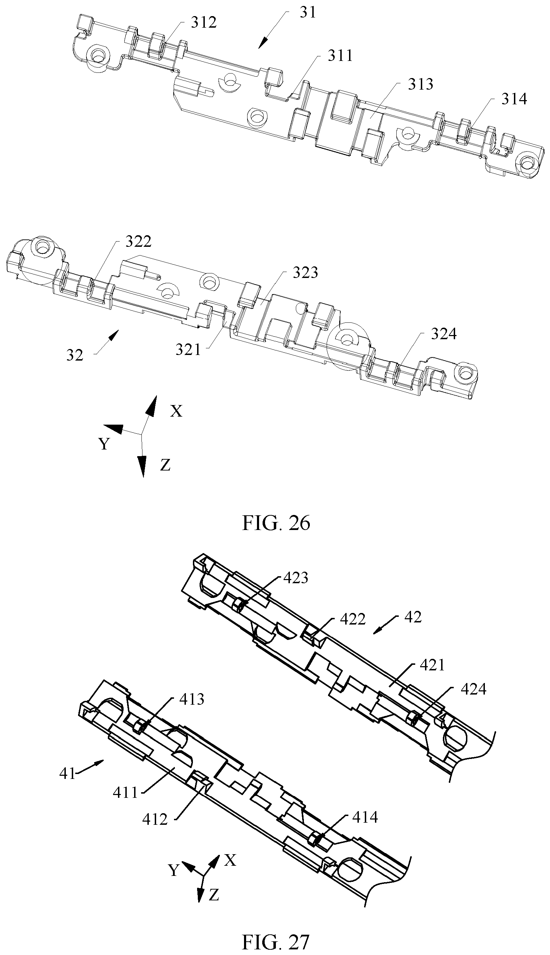

FIG. 26 is a schematic diagram of a structure of the fastened frame 30 in the first rotation assembly 101 of the rotation mechanism 100 shown in FIG. 5.

The fastened frame 30 in the first rotation assembly 101 includes the first fastened frame 31 and the second fastened frame 32. The first fastened frame 31 has a strip-shaped plate-like structure with a thickness. The first fastened frame 31 is provided with a first guide sliding slot 311, a first shaft hole 312, a first sliding slot 313, and a third shaft hole 314. The first guide sliding slot 311 is arc-shaped. The first guide sliding slot 311 is configured for being slidably connected to the first pressing plate 41. In this embodiment, three first guide sliding slots 311 are provided. The three first guide sliding slots 311 are arranged apart in a length direction (the Y direction) of the first fastened frame 31. An extension direction of the first shaft hole 312 is parallel to the X direction. The first shaft hole 312 is configured for being rotatably connected to the first main swing arm 21 in the first rotation assembly 101. The third shaft hole 314 is spaced apart from the first shaft hole 312. An extension direction of the third shaft hole 314 is parallel to the X direction. The third shaft hole 314 is configured for being rotatably connected to the third main swing arm 27 in the first rotation assembly 101. The first sliding slot 313 is provided in a top surface of the first fastened frame 31. An extension direction of the first sliding slot 313 is parallel to a width direction (the X direction) of the first fastened frame 31. The first sliding slot 313 is slidably connected to the first synchronization swing arm 51.

The second fastened frame 32 and the first fastened frame 31 are symmetric structures, and the second fastened frame 32 and the first fastened frame 31 are mirror-symmetric with respect to the reference plane P. The second fastened frame 32 is provided with a second guide sliding slot 321, a second shaft hole 322, a second sliding slot 323, and a fourth shaft hole 324. The second guide sliding slot 321 is configured for being slidably connected to the second pressing plate 42. In this embodiment, three second guide sliding slots 321 are provided. The three second guide sliding slots 321 are arranged apart in a length direction (the Y direction) of the second fastened frame 32. An extension direction of the second shaft hole 322 is parallel to the X direction. The second shaft hole 322 is configured for being rotatably connected to the second main swing arm 24 in the first rotation assembly 101. The fourth shaft hole 324 is spaced apart from the second shaft hole 322. An extension direction of the fourth shaft hole 324 is parallel to the X direction. The fourth shaft hole 324 is configured for being rotatably connected to the fourth main swing arm 28 in the first rotation assembly 101. The second sliding slot 323 is provided in a top surface of the second fastened frame 32. An extension direction of the second sliding slot 323 is parallel to a width direction (the X direction) of the second fastened frame 32. The second sliding slot 323 is slidably connected to the second synchronization swing arm 52.

FIG. 27 is a partial schematic diagram of a structure of the pressing plate 40 in the rotation mechanism 100 shown in FIG. 5.

The pressing plate 40 includes the first pressing plate 41 and the second pressing plate 42. The first pressing plate 41 includes a first body 411 and a first guide slider 412. The first body 411 has a strip-shaped plate-like structure. The first guide slider 412 is arc-shaped. A structure of the first guide slider 412 matches the structure of the first guide sliding slot 311. The first guide slider 412 is fastened to a bottom surface of the first body 411. The first guide slider 412 is configured for being mounted in the first guide sliding slot 311, to implement a rotatable and slidable connection with the first fastened frame 31. In this embodiment, three first guide sliders 412 are provided. The three first guide sliders 412 are spaced apart in a length direction (the Y direction) of the first body 411. In addition, the three first guide sliders 412 are disposed in a one-to-one correspondence with the three first guide sliding slots 311.

The first body 411 is provided with a first sliding hole 413 and a third sliding hole 414. The first sliding hole 413 is provided in the bottom surface of the first body 411. A depth direction of the first sliding hole 413 is parallel to the Y direction. The first sliding hole 413 is configured for implementing a rotatable and slidable connection between the first pressing plate 41 and the first main swing arm 21. In this embodiment, the first sliding hole 413 has a curved water-drop shape. A shape of the first sliding hole 413 is a shape of a cross-section of the first sliding hole 413. A cross-sectional direction is perpendicular to the depth direction of the first sliding hole 413. In other embodiments, the first sliding hole 413 may have a strip-shaped or another irregular-shape structure. The shape of the first sliding hole 413 is not specifically limited, provided that the first sliding hole 413 can implement a rotatable and slidable connection between the first pressing plate 41 and the first main swing arm 21.

A shape of the third sliding hole 414 is the same as or similar to the shape of the first sliding hole 413. The third sliding hole 414 is spaced apart from the first sliding hole 413. The third sliding hole 414 is configured for implementing a slidable and rotatable connection between the first pressing plate 41 and the third main swing arm 27.

The second pressing plate 42 and the first pressing plate 41 are symmetric structures, and the second pressing plate 42 and the first pressing plate 41 are mirror-symmetric with respect to the reference plane P. The second pressing plate 42 includes a second body 421 and a second guide slider 422. The second body 421 has a strip-shaped plate-like structure. The second guide slider 422 is arc-shaped. A structure of the second guide slider 422 matches the structure of the second guide sliding slot 321. The second guide slider 422 is fastened to a bottom surface of the second body 421. The second guide slider 422 is configured for being mounted in the second guide sliding slot 321, to implement a rotatable and slidable connection with the second fastened frame 32. In this embodiment, three second guide sliders 422 are provided. The three second guide sliders 422 are spaced apart in a length direction (the Y direction) of the second body 421. In addition, the three second guide sliders 422 are disposed in a one-to-one correspondence with the three second guide sliding slots 321.

The second body 421 is provided with a second sliding hole 423 and a fourth sliding hole 424. The second sliding hole 423 is provided in the bottom surface of the second body 421. A depth direction of the second sliding hole 423 is parallel to the Y direction. The second sliding hole 423 is configured for implementing a rotatable and slidable connection between the second main swing arm 24 and the second pressing plate 42. In this embodiment, the second sliding hole 423 has a curved water-drop shape. A shape of the fourth sliding hole 424 is the same as or similar to a shape of the second sliding hole 423. The fourth sliding hole 424 is spaced apart from the second sliding hole 423. The fourth sliding hole 424 is configured for implementing a slidable and rotatable connection between the second pressing plate and the third main swing arm 27.

With reference to FIG. 5 together, the first fastened frame 31, the first pressing plate 41, the first main swing arm 21, and the third main swing arm 27 are all located on a side of an X-axis positive direction of the base 10. The first pressing plate 41 is mounted in the first fastened frame 31, and is slidable and rotatable with respect to the first fastened frame 31. A bottom surface of the first pressing plate 41 faces the top surface of the first fastened frame 31. The first guide slider 412 is located in the first guide sliding slot 311, and is slidable along the first guide sliding slot 311. The first rotating body 22 of the first main swing arm 21 is mounted in the first rotating groove, and the first shaft seat 211 faces the first fastened frame 31. The rotation mechanism 100 further includes a first rotating shaft a and a second rotating shaft b. The first rotating shaft a is mounted in the first shaft hole 312, and is rotatable in the first shaft hole 312. The second rotating shaft b is mounted in the first sliding hole 413. The second rotating shaft b is rotatable in the first sliding hole 413 around an axial direction of the second rotating shaft, and is also slidable in the first sliding hole 413. The third main swing arm 27 is spaced apart from the first main swing arm 21. The third main swing arm 27 is rotatably connected to the first fastened frame 31, and is rotatably and slidably connected to the first pressing plate 41. The third main swing arm 27 is mounted in the third rotating groove, and is rotatable and slidable in the third rotating groove. For connection manners between the third main swing arm 27 and the first fastened frame 31 and the first pressing plate 41, refer to the first main swing arm 21. Details are not described herein. The first fastened frame 31 is fastened to the first housing 210.

The second fastened frame 32, the second pressing plate 42, the second main swing arm 24, and the fourth main swing arm 28 are all located on a side of an X-axis negative direction of the base 10. The second pressing plate 42 is mounted in the second fastened frame 32, and is slidable and rotatable with respect to the second fastened frame 32. A bottom surface of the second pressing plate 42 faces the top surface of the second fastened frame 32. The second guide slider 422 is located in the second guide sliding slot 321, and is slidable along the second guide sliding slot 321. The second rotating body 25 of the second main swing arm 24 is mounted in the second rotating groove, and the second shaft seat 241 faces the second fastened frame 32. The rotation mechanism 100 further includes a third rotating shaft c and a fourth rotating shaft d. The third rotating shaft c is mounted in the second shaft hole 322, and is rotatable in the second shaft hole 322. The third rotating shaft c is mounted in the second sliding hole 423, and the second rotating shaft is rotatable in the second sliding hole 423 around an axial direction of the third rotating shaft c, or is slidable in the second sliding hole 423. The fourth main swing arm 28 is spaced apart from the second main swing arm 24. The fourth main swing arm 28 is rotatably connected to the second fastened frame 32, and is rotatably and slidably connected to the second pressing plate 42. The fourth main swing arm 28 is mounted in the fourth rotating groove, and is rotatable and slidable in the fourth rotating groove. For connection manners between the fourth main swing arm 28 and the second fastened frame 32 and the second pressing plate 42, refer to the second main swing arm 24. Details are not described herein. The second fastened frame 32 is fastened to the second housing 220.

The first housing 210 rotates with respect to the base 10 to drive the first fastened frame 31 to rotate with respect to the base 10, to drive the first pressing plate 41 to rotate with respect to the base 10, and drive the first pressing plate 41 to rotate and slide along the first guide sliding slot 311 with respect to the first fastened frame 31. The first fastened frame 31 rotates with respect to the base 10 to further drive the first main swing arm 21 to rotate, and make the first rotating body 22 rotate and slide in the first rotating groove, the first rotating shaft a rotate in the first shaft hole 312, and the second rotating shaft b rotate and slide in the first sliding hole 413.

The second housing 220 rotates with respect to the base 10 to drive the second fastened frame 32 to rotate with respect to the base 10, to drive the second pressing plate 42 to rotate with respect to the base 10, and drive the second pressing plate 42 to rotate and slide along the second guide sliding slot 321 with respect to the second fastened frame 32. The second fastened frame 32 rotates with respect to the base 10 to further drive the second main swing arm 24 to rotate, and make the second rotating body 25 rotate and slide in the second rotating groove, the third rotating shaft c rotate in the second shaft hole 322, and the fourth rotating shaft d rotate and slide in the second sliding hole 423.

Rotation directions of the first housing 210 and the second housing 220 are opposite, rotation directions of the first fastened frame 31 and the second fastened frame 32 are opposite, rotation directions of the first pressing plate 41 and the second pressing plate 42 are opposite, and the rotation directions of the first main swing arm 21 and the second main swing arm 24 are opposite. For example, when the rotation mechanism 100 rotates from the flattened state to the folded state, the first fastened frame 31, the first pressing plate 41, and the first main swing arm 21 rotate counterclockwise, and the second fastened frame 32, the second pressing plate 42, the second main swing arm 24 rotate clockwise. When the rotation mechanism 100 rotates from the folded state to the flattened state, the first fastened frame 31, the first pressing plate 41, and the first main swing arm 21 rotate clockwise, and the second fastened frame 32, the second pressing plate 42, the second main swing arm 24 rotate counterclockwise.

In this embodiment, the first fastened frame 31 and the second fastened frame 32 are disposed, the first fastened frame 31 is fastened to the first housing 210, and the second fastened frame 32 is fastened to the second housing 220, so that connection strength of the fastened frame 30 and the housing can be increased, thereby improving the stability of the rotation of the foldable electronic device 1000.

The first pressing plate 41 and the second pressing plate 42 are disposed opposite to the display 300. In other words, orthographic projections of the display 300 onto the first pressing plate 41 and the second pressing plate 42 completely cover the first pressing plate 41 and the second pressing plate 42, or partially cover the first pressing plate 41 and the second pressing plate 42. The first pressing plate 41, the second pressing plate 42, and the support plate 13 jointly support the display 300, so that connection stability of the display 300 can be improved, thereby ensuring good display of the display 300.

In this embodiment, the first fastened frame 31 rotates to drive the first pressing plate 41 to rotate, and the second fastened frame 32 rotates to drive the second pressing plate 42 to rotate, to implement folding and unfolding of the display 300. In this embodiment, the guide sliding slot is provided in the first pressing plate 41, and an arc-shaped guide slider is disposed on the first fastened frame 31, so that arc-shaped sliding of the first pressing plate 41 with respect to the first fastened frame 31 can be implemented. The guide sliding slot is provided in the second pressing plate 42, and the arc-shaped guide slider is disposed on the second fastened frame 32, so that arc-shaped sliding of the second pressing plate 42 with respect to the second fastened frame 32 can be implemented. When the first fastened frame 31 and the second fastened frame 32 rotate, the first pressing plate 41 and the second pressing plate 42 rotate with respect to each other, the first pressing plate 41 makes arc-shaped sliding with respect to the first fastened frame 31, and the second pressing plate 42 makes arc-shaped sliding with respect to the second fastened frame 32, so that an angle between the first pressing plate 41 and the second pressing plate 42 can be adjusted, to adapt to a folding angle of the foldable part of the display 300, to keep the first pressing plate 41 and the second pressing plate 42 from pressing the display 300 when the rotation mechanism 100 is in the folded state. In other words, when the rotation mechanism 100 is in the folded state, an angle between the first fastened frame 31 and the second fastened frame 32 is different from the angle between the first pressing plate 41 and the second pressing plate 42, and the angle between the first pressing plate 41 and the second pressing plate 42 may be adjusted according to a bending angle of the display 300, to adapt to the bending of the display 300.

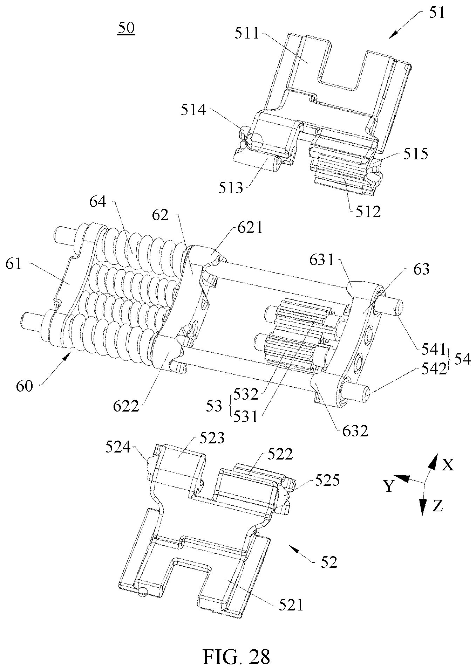

FIG. 28 is a partial schematic exploded view of a structure of the rotation mechanism 100 shown in FIG. 6.

The synchronization assembly 50 includes the first synchronization swing arm 51, the second synchronization swing arm 52, the synchronization gear 53, and the damping member 60. The synchronization gear 53 and the damping member 60 are both mounted on the base 10. The first synchronization swing arm 51 and the second synchronization swing arm 52 are respectively located on two opposite sides of the base 10 in the X direction, are engaged with the synchronization gear 53, and are also engaged with the damping member 60. When rotating, the first synchronization swing arm 51 drives the synchronization gear 53 to rotate to drive the second synchronization swing arm 52 to rotate, thereby implementing the synchronous movement of the first synchronization swing arm 51 and the second synchronization swing arm 52. In addition, when rotating, the first synchronization swing arm 51 and the second synchronization swing arm 52 abut against the damping member 60, so that the damping member 60 generates a damping force, thereby providing a damping force for rotation of the rotation mechanism 100 and providing a damping feel for the user.

The synchronization assembly 50 further includes a fastened rod 54. In this embodiment, two fastened rods 54 are provided. The two fastened rods 54 are respectively a first fastened rod 541 and a second fastened rod 542. The first fastened rod 541 and the second fastened rod 542 are spaced apart in the X direction. In addition, extension directions of the first fastened rod 541 and the second fastened rod 542 are both parallel to the Y direction, and are fastened to the base 10.

The damping member 60 includes a baffle plate 61, a first damping plate 62, a second damping plate 63, and a damping spring 64. The first damping plate 62 is provided with a first hinge seat 621 and a second hinge seat 622. The first hinge seat 621 includes a plurality of protrusions and a plurality of recesses. The plurality of protrusions and the plurality of recesses are alternately arranged to form an annular structure. A structure of the second hinge seat 622 is the same as or similar to a structure of the first hinge seat 621. The first hinge seat 621 and the second hinge seat 622 are spaced apart in the X direction. The second damping plate 63 is provided with a third hinge seat 631 and a fourth hinge seat 632. The third hinge seat 631 and the fourth hinge seat 632 are spaced apart in the X direction. Structures of the third hinge seat 631 and the fourth hinge seat 632 are the same as or similar to the structure of the first hinge seat 621.

The baffle plate 61, the first damping plate 62, and the second damping plate 63 are all sleeved over the fastened rod 54, and are sequentially arranged apart in the Y direction. The first damping plate 62 is located between the baffle plate 61 and the second damping plate 63. In addition, the baffle plate 61 and the second damping plate 63 are both fastened to the fastened rod 54. The first damping plate 62 is slidably connected to the fastened rod 54, and is movable in a length direction of the fastened rod 54. The first hinge seat 621 and the second hinge seat 622 face the second damping plate 63, and the third hinge seat 631 and the fourth hinge seat 632 face the first damping plate 62. The damping spring 64 is mounted between the baffle plate 61 and the first damping plate 62, and is fastened to the baffle plate 61 and the first damping plate 62.

In this embodiment, two synchronization gears 53 are provided. The two synchronization gears 53 are respectively a third gear 531 and a fourth gear 532. The third gear 531 and the fourth gear 532 are disposed side by side in the X direction, and are engaged with each other. The synchronization gears 53 are disposed between the two fastened rods 54, and are rotatably connected to the second damping plate 63.

The first synchronization swing arm 51 includes a first sliding body 511, a first gear 512, and a first rotating post 513. The first sliding body 511 has a plate-like structure. The first sliding body 511 is configured for being mounted in the first sliding slot 313, to make the first synchronization swing arm 51 slidably connected to the first fastened frame 31. The first rotating post 513 and the first gear 512 are disposed side by side in a width direction of the first sliding body 511, and are both connected to an end of the first synchronization swing arm 51. A first hinge body 514 is provided at an end of the first rotating post 513 facing away from the first gear 512. A third hinge body 515 is provided at an end of the first gear 512 facing away from the first rotating post 513. A structure of the first hinge body 514 matches the structure of the first hinge seat 621. A structure of the third hinge body 515 matches a structure of the third hinge seat 631. The first rotating post 513 and the first gear 512 both have hollow structures, and central axes of the first rotating post 513 and the first gear 512 coincide.

The first synchronization swing arm 51 is mounted on the first fastened rod 541. The first gear 512 and the first rotating post 513 are sleeved over a periphery of the first fastened rod 541, and is located between a first damping baffle plate 61 and a second damping baffle plate 61. The first gear 512 is engaged with the third gear 531, the first hinge body 514 is hinged to the first hinge seat 621, and the third hinge body 515 is hinged to the third hinge seat 631.

The second synchronization swing arm 52 includes a second sliding body 521, a second gear 522, and a second rotating post 523. The second sliding body 521 has a plate-like structure. The second sliding body 521 is configured for being mounted in the second sliding slot 323, to make the second synchronization swing arm 52 slidably connected to the second fastened frame 32. The second rotating post 523 and the second gear 522 are disposed side by side in a width direction of the second sliding body 521, and are both connected to an end of the second synchronization swing arm 52. A second hinge body 524 is provided at an end of the second rotating post 523 facing away from the second gear 522. A fourth hinge body 525 is provided at an end of the second gear 522 facing away from the second rotating post 523. A structure of the second hinge body 524 matches the structure of the second hinge seat 622, and a structure of the fourth hinge body 525 matches the structure of the fourth hinge seat 632. The second rotating post 523 and the second gear 522 both have hollow structures, and central axes of the second rotating post 523 and the second gear 522 coincide.

The second synchronization swing arm 52 is mounted on the second fastened rod 542. The second gear 522 and the second rotating post 523 are sleeved over a periphery of the second fastened rod 542, and is located between the first damping baffle plate 61 and the second damping baffle plate 61. The second gear 522 is engaged with the fourth gear 532, the second hinge body 524 is hinged to the second hinge seat 622, and the fourth hinge body 525 is hinged to the fourth hinge seat 632.

With reference to FIG. 5 and FIG. 6 together, the first synchronization assembly 501 is mounted on the base 10, the damping member 60 and the synchronization gear 53 are located in the base 10, a rotating rod is fastened to the base 10, and the first synchronization swing arm 51 and the second synchronization swing arm 52 are respectively located on two opposite sides of the base 10 in the X direction. The first synchronization swing arm 51 is located in the X-axis positive direction of the base 10, and the second synchronization swing arm 52 is located in the X-axis negative direction of the base 10. The first sliding body 511 is mounted in the first sliding slot 313 of the first fastened frame 31, and is slidable in the first sliding slot 313. The second sliding body 521 is mounted in the second sliding slot 323 of the second fastened frame 32, and is slidable in the second sliding slot 323.

When the rotation mechanism 100 is in the flattened state, the first synchronization swing arm 51 and the second synchronization swing arm 52 are unfolded with respect to each other, and an angle between the first synchronization swing arm 51 and the second synchronization swing arm 52 is approximately 180 degrees. When the rotation mechanism 100 is in the folded state, the first synchronization swing arm 51 and the second synchronization swing arm 52 are folded with respect to each other. In other words, the first synchronization swing arm 51 and the second synchronization swing arm 52 are approximately disposed in parallel.

When rotating with respect to the base 10, the first fastened frame 31 drives the first sliding body 511 to rotate with respect to the base 10, and at the same time slides in the first sliding slot 313. When rotating with respect to the base 10, the first sliding body 511 drives the first rotating post 513 and the first gear 512 to rotate around a first rotating rod, the first gear 512 rotates to drive the third gear 531 to rotate, the third gear 531 drives the fourth gear 532 to rotate, and the fourth gear 532 drives the second gear 522 to rotate around a second rotating rod. The second gear 522 rotates to drive the second sliding body 521 to rotate with respect to the base 10, makes the second sliding body 521 slide in the second sliding slot 323, and at the same time drives the second fastened frame 32 to rotate with respect to the base 10, thereby implementing synchronous rotation of the first synchronization swing arm 51 and the second synchronization swing arm 52 and synchronous rotation of the first fastened frame 31 and the second fastened frame 32. Rotation directions of the first synchronization swing arm 51 and the second synchronization swing arm 52 are opposite, and the rotation directions of the first fastened frame 31 and the second fastened frame 32 are opposite.

When rotating around the first rotating rod, the first synchronization swing arm 51 drives the first hinge body 514 and the third hinge body 515 to rotate, the third hinge body 515 repeatedly abuts against the third hinge seat 631, and the first hinge body 514 repeatedly abuts against the first hinge seat 621. When rotating around the second rotating rod, the second synchronization swing arm 52 drives the second hinge body 524 and the fourth hinge body 525 to rotate, the fourth hinge body 525 repeatedly abuts against the fourth hinge seat 632, and the second hinge body 524 repeatedly abuts against the second hinge seat 622. The first hinge body 514 and the second hinge body 524 repeatedly push the first damping baffle plate 61 to move toward the damping spring 64, and repeatedly press the damping spring 64 to make the damping spring 64 generate an elastic force. An elastic restoration force of the damping spring 64 acts on the first synchronization swing arm 51 and the second synchronization swing arm 52, to provide damping forces for rotation of the first synchronization swing arm 51 and the second synchronization swing arm 52, the damping force for the first synchronization swing arm 51 acts on the first housing 210 through the first fastened frame 31, and the damping force for the second synchronization swing arm 52 acts on the second housing 220 through the second fastened frame 32, to provide a damping feel for the user.

In this embodiment, the synchronization assembly 50 is disposed, and when rotating, the first synchronization swing arm 51 can drive, through the synchronization gear 53, the second synchronization swing arm 52 to rotate, so that synchronous rotation of the first synchronization swing arm 51 and the second synchronization swing arm 52 can be implemented, thereby implementing synchronous rotation of the rotation mechanism 100 and the foldable electronic device 1000, which facilitates use by the user, and improves the use experience of the user.

In this embodiment, the damping member 60 is disposed, and when the first synchronization swing arm 51 and the second synchronization swing arm 52 rotate with respect to the base 10, the damping member 60 remains abutting against the first synchronization swing arm 51 and the second synchronization swing arm 52, to generate a damping force, thereby providing a damping feel for a user, and improving the use experience of the user.

## Claims

1. A rotation mechanism, comprising a base (10), a first main swing arm (21), and a second main swing arm (24), wherein
the base is provided with a first rotating groove and a second rotating groove, and the first rotating groove and the second rotating groove are provided opposite to each other in a width direction of the rotation mechanism; and the base comprises a first stop surface (153), the first stop surface is located in the first rotating groove, and the first rotating groove comprises a first inner wall (151), the first inner wall is disposed facing away from the second rotating groove, and the first inner wall comprises the first stop surface, and a plane in which the first stop surface is located intersects a width direction of the base;
the first main swing arm comprises a second stop surface (23), and a plane in which the second stop surface is located intersects the width direction of the base;
the first main swing arm is mounted in the first rotating groove, the second stop surface faces the first rotating groove, and the first main swing arm is rotatable and slidable along the first rotating groove; and the second main swing arm is mounted in the second rotating groove, and the second main swing arm is rotatable and slidable along the second rotating groove; and
when the first main swing arm is unfolded with respect to the base, the first stop surface and the second stop surface are disposed opposite to each other, in the width direction of the base, the first main swing arm and the base are stopped, and the first main swing arm and the second main swing arm are rotatable toward each other, to make the first main swing arm folded with respect to the second main swing arm.

2. The rotation mechanism according to claim 1, wherein when the first main swing arm (21) is unfolded with respect to the base (10), the first stop surface (153) and the second stop surface abut against each other, and abutting force directions between the first stop surface and the second stop surface are consistent with the width direction of the base.

3. The rotation mechanism according to claim 2, wherein the base further comprises a first guide rail, the first guide rail is fastened on the first inner wall and extends in a direction away from the second rotating groove, and the first guide rail is disposed side by side with the first stop surface;
the first main swing arm comprises a first end (221), the first main swing arm is provided with a first groove (227), an opening of the first groove is located in a top surface or a bottom surface of the first main swing arm, and the first groove penetrates the first end; and
when the first main swing arm is mounted on the base, the first end faces the first rotating groove, at least a part of the first guide rail (172) is located in the first groove, and the first main swing arm is rotatable and slidable in the first rotating groove along the first guide rail.

4. The rotation mechanism according to claim 3, wherein in a length direction of the base, the first guide rail is disposed side by side with the first stop surface (153); and the opening of the first groove (227) is located at a bottom surface of the first main swing arm, and the second stop surface is disposed on a side wall of the first groove and faces the first end; and
when the first main swing arm is mounted on the base, the first guide rail is located on a side of the first groove facing away from a top surface of the base, and a top surface of the first guide rail is opposite to and in contact with a bottom wall surface of the groove.

5. The rotation mechanism according to claim 3, wherein in a thickness direction of the base (10), the first guide rail is disposed side by side with the first stop surface, and the first guide rail is located on a side of the first stop surface close to a top surface of the base; and the opening of the first groove is located at the top surface of the first main swing arm, and the second stop surface is disposed at the first end, and is connected between a bottom surface of the first main swing arm and a bottom wall surface of the first groove; and
when the first main swing arm is mounted on the base, the first guide rail is located on a side of the first groove close to the top surface of the base, and the bottom surface of the first guide rail is opposite to and in contact with a bottom wall surface of the groove.

6. The rotation mechanism according to claim 3, wherein the first stop surface (153) comprises a first sub-stop surface (155), in a thickness direction of the base, the first sub-stop surface is disposed side by side with the first guide rail (172), and the first sub-stop surface is located on a side of the first guide rail close to a top surface of the base;
the opening of the first groove (227) is located at a bottom surface of the first main swing arm, the second stop surface comprises a second sub-stop surface, and the second sub-stop surface is disposed at the first end, and is connected between the top surface of the first main swing arm and a bottom wall surface of the first groove;
when the first main swing arm is mounted on the base, the first guide rail is located on a side of the first groove facing away from the top surface of the base, and a top surface of the first guide rail is opposite to and in contact with the bottom wall surface of the first groove; and
when the first main swing arm is unfolded with respect to the base, the first sub-stop surface and the second sub-stop surface are disposed opposite to each other.

7. The rotation mechanism according to claim 6, wherein the first stop surface further comprises a third sub-stop surface (156), and in a length direction of the base, the third sub-stop surface is disposed side by side with the first guide rail; and the first main swing arm further comprises a fourth sub-stop surface (232), and the fourth sub-stop surface is disposed on a side wall of the first groove and faces the first end (221); and
when the first main swing arm is unfolded with respect to the base, the third sub-stop surface and the fourth sub-stop surface are disposed opposite to each other.

8. The rotation mechanism according to claim 3, wherein the first stop surface comprises a first sub-stop surface (155), and in a length direction of the base, the first guide rail (172) is disposed side by side with the first sub-stop surface;
the second stop surface comprises a second sub-stop surface, and the second sub-stop surface is disposed at an end of the first main swing arm, and is connected between the top surface of the first main swing arm and a bottom surface of the first main swing arm (21); and
when the first main swing arm is unfolded with respect to the base, the first sub-stop surface and the second sub-stop surface are disposed opposite to each other.

9. The rotation mechanism according to claim 8, wherein the first stop surface further comprises a third sub-stop surface, in the length direction of the base, the third sub-stop surface is disposed side by side with the first stop surface and the first guide rail, and the third sub-stop surface is located between the first sub-stop surface and the first guide rail;
the opening of the first groove is located at the bottom surface of the first main swing arm; and the second stop surface further comprises a fourth sub-stop surface (232), and the fourth sub-stop surface is disposed on a side wall of the first groove and faces the first end (221);
when the first main swing arm is mounted on the base, the first guide rail is located on a side of the first groove facing away from a top surface of the base, and a top surface of the first guide rail is opposite to and in contact with a bottom wall surface of the first groove; and
when the first main swing arm is unfolded with respect to the base, the third sub-stop surface and the fourth sub-stop surface are disposed opposite to each other.

10. The rotation mechanism according to any one of claims 1 to 9, wherein the first stop surface (153) and the second stop surface (23) are in an interference fit.

11. The rotation mechanism according to claim 10, wherein an interference amount between the first stop surface and the second stop surface (23) ranges from 0 mm to 0.1 mm.

12. The rotation mechanism according to any one of claims 1 to 9, wherein the rotation mechanism further comprises a wear-resistant layer, and the wear-resistant layer is disposed on the first stop surface or/and the second stop surface (23).

13. The rotation mechanism according to any one of claims 1 to 9, wherein the rotation mechanism has a folded state and an unfolded state, when the rotation mechanism is switched from the unfolded state to the folded state, the first main swing arm rotates in a first direction, and when the rotation mechanism is in the unfolded state, the first main swing arm and the base (10) are stopped in a second direction; and the second direction is opposite to the first direction.

14. The rotation mechanism according to any one of claims 1 to 9, wherein the base (10) comprises a shaft cover (11) and a support plate (13), and the shaft cover and the support plate are stacked and are fastened to each other; and when the first main swing arm and the second main swing arm (24) are unfolded with respect to each other, the top surface of the first main swing arm and a top surface of the second main swing arm are both flush with a surface of the support plate facing away from the shaft cover.

15. A foldable electronic device, comprising a first housing (210), a second housing (220), a display (300), and the rotation mechanism according to any one of claims 1 to 14, wherein the rotation mechanism is connected between the first housing and the second housing, the display is mounted on the first housing, the second housing, and the rotation mechanism, and when the rotation mechanism rotates, the first housing and the second housing rotate with respect to each other, to drive the display to bend or unfold.

## Patentansprüche

1. Drehmechanismus, umfassend eine Basis (10), einen ersten Hauptschwenkarm (21) und einen zweiten Hauptschwenkarm (24), wobei
die Basis mit einer ersten Drehnut und einer zweiten Drehnut versehen ist und die erste Drehnut und die zweite Drehnut in einer Breitenrichtung des Drehmechanismus einander gegenüberliegend vorgesehen sind; und die Basis eine erste Anschlagfläche (153) umfasst, die erste Anschlagfläche sich in der ersten Drehnut befindet, und die erste Drehnut eine erste Innenwand (151) umfasst, die erste Innenwand von der zweiten Drehnut abgewandt angeordnet ist, und die erste Innenwand die erste Anschlagfläche umfasst, und eine Ebene, in der sich die erste Anschlagfläche befindet, eine Breitenrichtung der Basis schneidet;
der erste Hauptschwenkarm eine zweite Anschlagfläche (23) umfasst, und eine Ebene, in der sich die zweite Anschlagfläche befindet, die Breitenrichtung der Basis schneidet;
der erste Hauptschwenkarm in der ersten Drehnut montiert ist, die zweite Anschlagfläche der ersten Drehnut zugewandt ist und der erste Hauptschwenkarm entlang der ersten Drehnut drehbar und verschiebbar ist; und der zweite Hauptschwenkarm in der zweiten Drehnut montiert ist und der zweite Hauptschwenkarm entlang der zweiten Drehnut drehbar und verschiebbar ist; und
wenn der erste Hauptschwenkarm in Bezug auf die Basis entfaltet ist, die erste Anschlagfläche und die zweite Anschlagfläche einander gegenüberliegend angeordnet sind, in der Breitenrichtung der Basis der erste Hauptschwenkarm und die Basis angeschlagen sind, und der erste Hauptschwenkarm und der zweite Hauptschwenkarm zueinander hin drehbar sind, um den ersten Hauptschwenkarm in Bezug auf den zweiten Hauptschwenkarm zu falten.

2. Drehmechanismus nach Anspruch 1, wobei, wenn der erste Hauptschwenkarm (21) in Bezug auf die Basis (10) entfaltet ist, die erste Anschlagfläche (153) und die zweite Anschlagfläche aneinander anliegen und Anlagekraftrichtungen zwischen der ersten Anschlagfläche und der zweiten Anschlagfläche mit der Breitenrichtung der Basis übereinstimmen.

3. Drehmechanismus nach Anspruch 2, wobei die Basis ferner eine erste Führungsschiene umfasst, die erste Führungsschiene an der ersten Innenwand befestigt ist und sich in einer Richtung weg von der zweiten Drehnut erstreckt, und die erste Führungsschiene nebeneinander mit der ersten Anschlagfläche angeordnet ist;
der erste Hauptschwenkarm ein erstes Ende (221) umfasst, der erste Hauptschwenkarm mit einer ersten Nut (227) versehen ist, eine Öffnung der ersten Nut sich in einer oberen Fläche oder einer unteren Fläche des ersten Hauptschwenkarms befindet, und die erste Nut das erste Ende durchdringt; und
wenn der erste Hauptschwenkarm an der Basis montiert ist, das erste Ende der ersten Drehnut zugewandt ist, mindestens ein Teil der ersten Führungsschiene (172) sich in der ersten Nut befindet, und der erste Hauptschwenkarm in der ersten Drehnut entlang der ersten Führungsschiene drehbar und verschiebbar ist.

4. Drehmechanismus nach Anspruch 3, wobei in einer Längenrichtung der Basis die erste Führungsschiene nebeneinander mit der ersten Anschlagfläche (153) angeordnet ist; und die Öffnung der ersten Nut (227) sich an einer unteren Fläche des ersten Hauptschwenkarms befindet, und die zweite Anschlagfläche an einer Seitenwand der ersten Nut angeordnet ist und dem ersten Ende zugewandt ist; und
wenn der erste Hauptschwenkarm an der Basis montiert ist, die erste Führungsschiene sich auf einer von einer oberen Fläche der Basis abgewandten Seite der ersten Nut befindet, und eine obere Fläche der ersten Führungsschiene einer Bodenwandfläche der Nut gegenüberliegt und mit dieser in Kontakt steht.

5. Drehmechanismus nach Anspruch 3, wobei in einer Dickenrichtung der Basis (10) die erste Führungsschiene nebeneinander mit der ersten Anschlagfläche angeordnet ist, und die erste Führungsschiene sich auf einer einer oberen Fläche der Basis zugewandten Seite der ersten Anschlagfläche befindet; und die Öffnung der ersten Nut sich an der oberen Fläche des ersten Hauptschwenkarms befindet, und die zweite Anschlagfläche am ersten Ende angeordnet ist und zwischen einer unteren Fläche des ersten Hauptschwenkarms und einer Bodenwandfläche der ersten Nut verbunden ist; und
wenn der erste Hauptschwenkarm an der Basis montiert ist, die erste Führungsschiene sich auf einer der oberen Fläche der Basis zugewandten Seite der ersten Nut befindet, und die untere Fläche der ersten Führungsschiene einer Bodenwandfläche der Nut gegenüberliegt und mit dieser in Kontakt steht.

6. Drehmechanismus nach Anspruch 3, wobei die erste Anschlagfläche (153) eine erste Teilanschlagfläche (155) umfasst, in einer Dickenrichtung der Basis die erste Teilanschlagfläche nebeneinander mit der ersten Führungsschiene (172) angeordnet ist, und die erste Teilanschlagfläche sich auf einer einer oberen Fläche der Basis zugewandten Seite der ersten Führungsschiene befindet;
die Öffnung der ersten Nut (227) sich an einer unteren Fläche des ersten Hauptschwenkarms befindet, die zweite Anschlagfläche eine zweite Teilanschlagfläche umfasst, und die zweite Teilanschlagfläche am ersten Ende angeordnet ist und zwischen der oberen Fläche des ersten Hauptschwenkarms und einer Bodenwandfläche der ersten Nut verbunden ist;
wenn der erste Hauptschwenkarm an der Basis montiert ist, die erste Führungsschiene sich auf einer von der oberen Fläche der Basis abgewandten Seite der ersten Nut befindet, und eine obere Fläche der ersten Führungsschiene der Bodenwandfläche der ersten Nut gegenüberliegt und mit dieser in Kontakt steht; und
wenn der erste Hauptschwenkarm in Bezug auf die Basis entfaltet ist, die erste Teilanschlagfläche und die zweite Teilanschlagfläche einander gegenüberliegend angeordnet sind.

7. Drehmechanismus nach Anspruch 6, wobei die erste Anschlagfläche ferner eine dritte Teilanschlagfläche (156) umfasst, und in einer Längenrichtung der Basis die dritte Teilanschlagfläche nebeneinander mit der ersten Führungsschiene angeordnet ist; und der erste Hauptschwenkarm ferner eine vierte Teilanschlagfläche (232) umfasst, und die vierte Teilanschlagfläche an einer Seitenwand der ersten Nut angeordnet ist und dem ersten Ende (221) zugewandt ist; und
wenn der erste Hauptschwenkarm in Bezug auf die Basis entfaltet ist, die dritte Teilanschlagfläche und die vierte Teilanschlagfläche einander gegenüberliegend angeordnet sind.

8. Drehmechanismus nach Anspruch 3, wobei die erste Anschlagfläche eine erste Teilanschlagfläche (155) umfasst, und in einer Längenrichtung der Basis die erste Führungsschiene (172) nebeneinander mit der ersten Teilanschlagfläche angeordnet ist;
die zweite Anschlagfläche eine zweite Teilanschlagfläche umfasst, und die zweite Teilanschlagfläche an einem Ende des ersten Hauptschwenkarms angeordnet ist und zwischen der oberen Fläche des ersten Hauptschwenkarms und einer unteren Fläche des ersten Hauptschwenkarms (21) verbunden ist; und
wenn der erste Hauptschwenkarm in Bezug auf die Basis entfaltet ist, die erste Teilanschlagfläche und die zweite Teilanschlagfläche einander gegenüberliegend angeordnet sind.

9. Drehmechanismus nach Anspruch 8, wobei die erste Anschlagfläche ferner eine dritte Teilanschlagfläche umfasst, in der Längenrichtung der Basis die dritte Teilanschlagfläche nebeneinander mit der ersten Anschlagfläche und der ersten Führungsschiene angeordnet ist, und die dritte Teilanschlagfläche sich zwischen der ersten Teilanschlagfläche und der ersten Führungsschiene befindet;
die Öffnung der ersten Nut sich an der unteren Fläche des ersten Hauptschwenkarms befindet; und die zweite Anschlagfläche ferner eine vierte Teilanschlagfläche (232) umfasst, und die vierte Teilanschlagfläche an einer Seitenwand der ersten Nut angeordnet ist und dem ersten Ende (221) zugewandt ist;
wenn der erste Hauptschwenkarm an der Basis montiert ist, die erste Führungsschiene sich auf einer von einer oberen Fläche der Basis abgewandten Seite der ersten Nut befindet, und eine obere Fläche der ersten Führungsschiene einer Bodenwandfläche der ersten Nut gegenüberliegt und mit dieser in Kontakt steht; und
wenn der erste Hauptschwenkarm in Bezug auf die Basis entfaltet ist, die dritte Teilanschlagfläche und die vierte Teilanschlagfläche einander gegenüberliegend angeordnet sind.

10. Drehmechanismus nach einem der Ansprüche 1 bis 9, wobei die erste Anschlagfläche (153) und die zweite Anschlagfläche (23) in einer Übermaßpassung stehen.

11. Drehmechanismus nach Anspruch 10, wobei ein Übermaß zwischen der ersten Anschlagfläche und der zweiten Anschlagfläche (23) im Bereich von 0 mm bis 0,1 mm liegt.

12. Drehmechanismus nach einem der Ansprüche 1 bis 9, wobei der Drehmechanismus ferner eine verschleißfeste Schicht umfasst und die verschleißfeste Schicht auf der ersten Anschlagfläche und/oder der zweiten Anschlagfläche (23) angeordnet ist.

13. Drehmechanismus nach einem der Ansprüche 1 bis 9, wobei der Drehmechanismus einen gefalteten Zustand und einen entfalteten Zustand aufweist, wenn der Drehmechanismus vom entfalteten Zustand in den gefalteten Zustand geschaltet wird, der erste Hauptschwenkarm sich in einer ersten Richtung dreht, und wenn der Drehmechanismus sich im entfalteten Zustand befindet, der erste Hauptschwenkarm und die Basis (10) in einer zweiten Richtung angeschlagen sind; und die zweite Richtung der ersten Richtung entgegengesetzt ist.

14. Drehmechanismus nach einem der Ansprüche 1 bis 9, wobei die Basis (10) eine Wellenabdeckung (11) und eine Trägerplatte (13) umfasst, und die Wellenabdeckung und die Trägerplatte gestapelt sind und aneinander befestigt sind; und wenn der erste Hauptschwenkarm und der zweite Hauptschwenkarm (24) in Bezug zueinander entfaltet sind, die obere Fläche des ersten Hauptschwenkarms und eine obere Fläche des zweiten Hauptschwenkarms beide bündig mit einer von der Wellenabdeckung abgewandten Fläche der Trägerplatte abschließen.

15. Faltbare elektronische Vorrichtung, umfassend ein erstes Gehäuse (210), ein zweites Gehäuse (220), eine Anzeige (300) und den Drehmechanismus nach einem der Ansprüche 1 bis 14, wobei der Drehmechanismus zwischen dem ersten Gehäuse und dem zweiten Gehäuse verbunden ist, die Anzeige an dem ersten Gehäuse, dem zweiten Gehäuse und dem Drehmechanismus montiert ist, und wenn sich der Drehmechanismus dreht, das erste Gehäuse und das zweite Gehäuse sich in Bezug zueinander drehen, um die Anzeige anzutreiben, sich zu biegen oder zu entfalten.

## Revendications

1. Mécanisme de rotation, comprenant une base (10), un premier bras oscillant principal (21) et un second bras oscillant principal (24), dans lequel
la base est pourvue d'une première rainure de rotation et d'une seconde rainure de rotation, et la première rainure de rotation et la seconde rainure de rotation sont prévues à l'opposé l'une de l'autre dans une direction de la largeur du mécanisme de rotation ; et la base comprend une première surface de butée (153), la première surface de butée est située dans la première rainure de rotation, et la première rainure de rotation comprend une première paroi interne (151), la première paroi interne est disposée à l'opposé de la seconde rainure de rotation, et la première paroi interne comprend la première surface de butée, et un plan dans lequel se trouve la première surface de butée coupe une direction de la largeur de la base ;
le premier bras oscillant principal comprend une seconde surface de butée (23), et un plan dans lequel se trouve la seconde surface de butée coupe la direction de la largeur de la base ;
le premier bras oscillant principal est monté dans la première rainure de rotation, la seconde surface de butée fait face à la première rainure de rotation, et le premier bras oscillant principal peut tourner et coulisser le long de la première rainure de rotation ; et le second bras oscillant principal est monté dans la seconde rainure de rotation, et le second bras oscillant principal peut tourner et coulisser le long de la seconde rainure de rotation ; et
lorsque le premier bras oscillant principal est déployé par rapport à la base, la première surface de butée et la seconde surface de butée sont disposées à l'opposé l'une de l'autre, dans la direction de la largeur de la base, le premier bras oscillant principal et la base sont en butée, et le premier bras oscillant principal et le second bras oscillant principal peuvent tourner l'un vers l'autre, pour faire en sorte que le premier bras oscillant principal soit plié par rapport au second bras oscillant principal.

2. Mécanisme de rotation selon la revendication 1, dans lequel lorsque le premier bras oscillant principal (21) est déployé par rapport à la base (10), la première surface de butée (153) et la seconde surface de butée viennent en appui l'une contre l'autre, et des directions de force d'appui entre la première surface de butée et la seconde surface de butée sont cohérentes avec la direction de la largeur de la base.

3. Mécanisme de rotation selon la revendication 2, dans lequel la base comprend en outre un premier rail de guidage, le premier rail de guidage est fixé sur la première paroi interne et s'étend dans une direction s'éloignant de la seconde rainure de rotation, et le premier rail de guidage est disposé côte à côte avec la première surface de butée ;
le premier bras oscillant principal comprend une première extrémité (221), le premier bras oscillant principal est pourvu d'une première rainure (227), une ouverture de la première rainure est située dans une surface supérieure ou une surface inférieure du premier bras oscillant principal, et la première rainure traverse la première extrémité ; et
lorsque le premier bras oscillant principal est monté sur la base, la première extrémité fait face à la première rainure de rotation, au moins une partie du premier rail de guidage (172) est située dans la première rainure, et le premier bras oscillant principal peut tourner et coulisser dans la première rainure de rotation le long du premier rail de guidage.

4. Mécanisme de rotation selon la revendication 3, dans lequel dans une direction de la longueur de la base, le premier rail de guidage est disposé côte à côte avec la première surface de butée (153) ; et l'ouverture de la première rainure (227) est située au niveau d'une surface inférieure du premier bras oscillant principal, et la seconde surface de butée est disposée sur une paroi latérale de la première rainure et fait face à la première extrémité ; et
lorsque le premier bras oscillant principal est monté sur la base, le premier rail de guidage est situé sur un côté de la première rainure orienté à l'opposé d'une surface supérieure de la base, et une surface supérieure du premier rail de guidage est opposée à et en contact avec une surface de paroi de fond de la première rainure.

5. Mécanisme de rotation selon la revendication 3, dans lequel dans une direction de l'épaisseur de la base (10), le premier rail de guidage est disposé côte à côte avec la première surface de butée, et le premier rail de guidage est situé sur un côté de la première surface de butée proche d'une surface supérieure de la base ; et l'ouverture de la première rainure est située au niveau de la surface supérieure du premier bras oscillant principal, et la seconde surface de butée est disposée au niveau de la première extrémité, et est reliée entre une surface inférieure du premier bras oscillant principal et une surface de paroi de fond de la première rainure ; et
lorsque le premier bras oscillant principal est monté sur la base, le premier rail de guidage est situé sur un côté de la première rainure proche de la surface supérieure de la base, et la surface inférieure du premier rail de guidage est opposée à et en contact avec une surface de paroi de fond de la première rainure.

6. Mécanisme de rotation selon la revendication 3, dans lequel la première surface de butée (153) comprend une première sous-surface de butée (155), dans une direction de l'épaisseur de la base, la première sous-surface de butée est disposée côte à côte avec le premier rail de guidage (172), et la première sous-surface de butée est située sur un côté du premier rail de guidage proche d'une surface supérieure de la base ;
l'ouverture de la première rainure (227) est située au niveau d'une surface inférieure du premier bras oscillant principal, la seconde surface de butée comprend une deuxième sous-surface de butée, et la deuxième sous-surface de butée est disposée au niveau de la première extrémité, et est reliée entre la surface supérieure du premier bras oscillant principal et une surface de paroi de fond de la première rainure ;
lorsque le premier bras oscillant principal est monté sur la base, le premier rail de guidage est situé sur un côté de la première rainure orienté à l'opposé de la surface supérieure de la base, et une surface supérieure du premier rail de guidage est opposée à et en contact avec la surface de paroi de fond de la première rainure ; et
lorsque le premier bras oscillant principal est déployé par rapport à la base, la première sous-surface de butée et la deuxième sous-surface de butée sont disposées à l'opposé l'une de l'autre.

7. Mécanisme de rotation selon la revendication 6, dans lequel la première surface de butée comprend en outre une troisième sous-surface de butée (156), et dans une direction de la longueur de la base, la troisième sous-surface de butée est disposée côte à côte avec le premier rail de guidage ; et le premier bras oscillant principal comprend en outre une quatrième sous-surface de butée (232), et la quatrième sous-surface de butée est disposée sur une paroi latérale de la première rainure et fait face à la première extrémité (221) ; et
lorsque le premier bras oscillant principal est déployé par rapport à la base, la troisième sous-surface de butée et la quatrième sous-surface de butée sont disposées à l'opposé l'une de l'autre.

8. Mécanisme de rotation selon la revendication 3, dans lequel la première surface de butée comprend une première sous-surface de butée (155), et dans une direction de la longueur de la base, le premier rail de guidage (172) est disposé côte à côte avec la première sous-surface de butée ;
la seconde surface de butée comprend une deuxième sous-surface de butée, et la deuxième sous-surface de butée est disposée au niveau d'une extrémité du premier bras oscillant principal, et est reliée entre la surface supérieure du premier bras oscillant principal et une surface inférieure du premier bras oscillant principal (21) ; et
lorsque le premier bras oscillant principal est déployé par rapport à la base, la première sous-surface de butée et la deuxième sous-surface de butée sont disposées à l'opposé l'une de l'autre.

9. Mécanisme de rotation selon la revendication 8, dans lequel la première surface de butée comprend en outre une troisième sous-surface de butée, dans la direction de la longueur de la base, la troisième sous-surface de butée est disposée côte à côte avec la première surface de butée et le premier rail de guidage, et la troisième sous-surface de butée est située entre la première sous-surface de butée et le premier rail de guidage ;
l'ouverture de la première rainure est située au niveau de la surface inférieure du premier bras oscillant principal ; et la seconde surface de butée comprend en outre une quatrième sous-surface de butée (232), et la quatrième sous-surface de butée est disposée sur une paroi latérale de la première rainure et fait face à la première extrémité (221) ;
lorsque le premier bras oscillant principal est monté sur la base, le premier rail de guidage est situé sur un côté de la première rainure orienté à l'opposé d'une surface supérieure de la base, et une surface supérieure du premier rail de guidage est opposée à et en contact avec une surface de paroi de fond de la première rainure ; et
lorsque le premier bras oscillant principal est déployé par rapport à la base, la troisième sous-surface de butée et la quatrième sous-surface de butée sont disposées à l'opposé l'une de l'autre.

10. Mécanisme de rotation selon l'une quelconque des revendications 1 à 9, dans lequel la première surface de butée (153) et la seconde surface de butée (23) sont dans un ajustement avec serrage.

11. Mécanisme de rotation selon la revendication 10, dans lequel une valeur de serrage entre la première surface de butée et la seconde surface de butée (23) est comprise entre 0 mm et 0,1 mm.

12. Mécanisme de rotation selon l'une quelconque des revendications 1 à 9, dans lequel le mécanisme de rotation comprend en outre une couche résistante à l'usure, et la couche résistante à l'usure est disposée sur la première surface de butée et/ou la seconde surface de butée (23).

13. Mécanisme de rotation selon l'une quelconque des revendications 1 à 9, dans lequel le mécanisme de rotation a un état plié et un état déployé, lorsque le mécanisme de rotation est commuté de l'état déployé à l'état plié, le premier bras oscillant principal tourne dans une première direction, et lorsque le mécanisme de rotation est dans l'état déployé, le premier bras oscillant principal et la base (10) sont en butée dans une seconde direction ; et la seconde direction est opposée à la première direction.

14. Mécanisme de rotation selon l'une quelconque des revendications 1 à 9, dans lequel la base (10) comprend un couvercle d'arbre (11) et une plaque de support (13), et le couvercle d'arbre et la plaque de support sont empilés et sont fixés l'un à l'autre ; et lorsque le premier bras oscillant principal et le second bras oscillant principal (24) sont déployés l'un par rapport à l'autre, la surface supérieure du premier bras oscillant principal et une surface supérieure du second bras oscillant principal affleurent toutes deux une surface de la plaque de support orientée à l'opposé du couvercle d'arbre.

15. Dispositif électronique pliable, comprenant un premier boîtier (210), un second boîtier (220), un écran (300), et le mécanisme de rotation selon l'une quelconque des revendications 1 à 14, dans lequel le mécanisme de rotation est relié entre le premier boîtier et le second boîtier, l'écran est monté sur le premier boîtier, le second boîtier et le mécanisme de rotation, et lorsque le mécanisme de rotation tourne, le premier boîtier et le second boîtier tournent l'un par rapport à l'autre, pour entraîner l'écran à se plier ou se déployer.
